(19) Europäisches Patentamt
European Patent Office
Office européen des brevets

(11) **EP 2 127 112 B1**

(12) **FASCICULE DE BREVET EUROPEEN**

(45) Date de publication et mention
de la délivrance du brevet:
**01.08.2012 Bulletin 2012/31**

(21) Numéro de dépôt: **08709100.5**

(22) Date de dépôt: **19.02.2008**

(51) Int Cl.:
***H04B 1/69*** *(2011.01)*

(86) Numéro de dépôt international:
**PCT/EP2008/052006**

(87) Numéro de publication internationale:
**WO 2008/101927 (28.08.2008 Gazette 2008/35)**

(54) **DISPOSITIF EMETTEUR RADIO**

FUNKÜBERTRAGUNGSEINRICHTUNG

RADIO TRANSMISSION DEVICE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **20.02.2007 FR 0753371**

(43) Date de publication de la demande:
**02.12.2009 Bulletin 2009/49**

(73) Titulaire: **Commissariat à l'Énergie Atomique et aux Énergies Alternatives 75015 Paris (FR)**

(72) Inventeur: **LACHARTRE, David**
**F-38330 Montbonnot (FR)**

(74) Mandataire: **Ilgart, Jean-Christophe et al BREVALEX**
**95 rue d'Amsterdam**
**75378 Paris Cedex 8 (FR)**

(56) Documents cités:
**WO-A-2004/036810      GB-A- 2 401 016**
**US-B2- 6 985 532**

**Description**

**DOMAINE TECHNIQUE ET ART ANTÉRIEUR**

L'invention concerne le domaine de la transmission de données, et particulièrement l'émission d'impulsions de courte durée (quelques nanosecondes) générées afin de constituer le support de transmission d'informations, par exemple à une fréquence comprise entre environ 1 GHz et 10 GHz, tel une impulsion de type à bande ultra large (« Ultra-WideBand » en anglais, ou UWB) ou une émission de données selon la norme IEEE 802.15.4a.

Une impulsion de courte durée peut être générée par une modulation d'une fréquence porteuse ou construite sans recours à une porteuse.

Dans le cas d'une impulsion générée par modulation d'une fréquence porteuse, le dispositif émetteur utilise un générateur de signal périodique formant une porteuse de fréquence en général égale à la fréquence centrale du spectre souhaité. Une modulation de cette porteuse est ensuite réalisée par un mélangeur multipliant cette porteuse à un signal d'enveloppe. Ce signal d'enveloppe peut être lui-même une impulsion de forme diverse dont la longueur va caractériser la largeur spectrale du signal résultant. Une impulsion de courte durée fournit un spectre plus large qu'une impulsion de durée plus longue. Cette modulation peut également être réalisée en quadrature comme dans un système bande étroite.

Les documents « Gaussian Pulse Generators for Subbanded Ultra-Wideband Transmitters » de D. Wentzloff et al., IEEE Transactions on Microwave Theory and Technics, Vol. 54, No. 4, avril 2006, et « Novel Pulse Generator Architecture Dedicated to Low Data Rate UWB Systems » de D. Marchaland et al., IEEE Wireless Technology 2005, the European Conference, 3 et 4 octobre 2005, décrivent de tels dispositifs émetteurs.

La génération d'impulsions par modulation d'une fréquence porteuse permet d'utiliser des blocs radio classiques tels que des mélangeurs, des oscillateurs commandés en tension (VCO pour « Voltage Control Oscillator »), des boucles à verrouillage de phase (PLL pour « Phase Locked Loop »), etc. De plus, en ne changeant que la fréquence de la porteuse, on déplace facilement la bande spectrale du signal à émettre. La puissance d'émission du signal de sortie peut en outre être ajustée par l'intermédiaire du signal enveloppe.

Toutefois, cette technique de génération d'impulsions nécessite de recourir à une synthèse de fréquences de type PLL, consommant en permanence de l'énergie. De plus, la présence de fuites de la porteuse au niveau de la sortie du dispositif émetteur, c'est-à-dire des émissions parasites de cette porteuse en sortie du dispositif émetteur lorsque aucun signal ne doit être émis, pose des difficultés pour supprimer cette porteuse du spectre d'émission. Enfin, un amplificateur de puissance large bande, qui est difficile à réaliser, est généralement nécessaire au dispositif émetteur.

Il existe plusieurs solutions pour obtenir une impulsion qui n'est pas générée à partir d'une porteuse. Ce type d'impulsion peut être obtenu par exemple en réalisant :

- de multiples dérivations d'un signal échelon, comme par exemple décrit dans les documents US 6 603 818 et US 6 625 229,
- la combinaison de plusieurs échelons retardés dans le temps, comme par exemple décrit dans le document EP 1 376 149,
- la somme d'impulsions simples retardées dans le temps, comme par exemple décrit dans les documents US 7 010 056 et US 6 735 238. GB 2401016 divulgue un dispositif pour la génération rapide d'une forme d'onde UWB.

En général ces solutions sont efficaces en matière de simplicité, de puissance consommée et de largeur de spectre qui peut alors être très grande. Elles peuvent souvent se passer d'un amplificateur de puissance et/ou utiliser des amplificateurs simples.

Toutefois, les émetteurs utilisant ce type de solution sont beaucoup moins efficaces que les émetteurs à génération d'impulsions par modulation de fréquence porteuse pour ce qui est de la commande de la forme d'impulsion et de sa réponse spectrale. Par exemple, pour décaler la bande spectrale de l'émetteur, il est nécessaire de recourir à un filtrage du signal construit, réduisant également la puissance émise. Enfin, la puissance d'émission est également difficilement ajustable avec ce type de générateur.

Le document US 6 985 532 décrit un générateur d'impulsions dans lequel les impulsions sont construites à partir d'échelons de durées et/ou d'amplitudes différentes, ajoutés en sortie les uns aux autres grâce à des signaux de commande mémorisés dans une mémoire. Ce dispositif fait appel à une horloge appliquée en entrée à générateur d'impulsions, fonctionnant de manière permanente, et représentant donc une source importante de consommation énergétique.

**EXPOSÉ DE L'INVENTION**

Un but de la présente invention est de proposer un dispositif émetteur basse consommation, permettant la génération d'impulsions de forme variable.

Pour cela, il est proposé un dispositif émetteur, comportant au moins :

- une ligne à retards apte à délivrer M signaux retardés les uns par rapport aux autres, M étant un entier non nul,
- une mémoire, destinée à stocker au moins M échantillons numériques d'une forme d'onde, et à délivrer en sortie chacun des M échantillons numériques respectivement par la commande d'un des M signaux retardés,
- un convertisseur numérique-analogique apte à réaliser une conversion des M échantillons numériques de la forme d'onde en un signal analogique.

La présente invention concerne en outre un dispositif émetteur comportant au moins :

- une ligne à retards apte à délivrer M signaux retardés les uns par rapport aux autres, M étant un entier supérieur à 1,
- une mémoire, destinée à stocker au moins M échantillons numériques d'une forme d'onde, chaque échantillon numérique comportant N bits, et à délivrer successivement chacun des M échantillons numériques sur N lignes de sorties, respectivement par la commande d'un des M signaux retardés,
- un convertisseur numérique-analogique comportant N entrées reliées aux N lignes de sorties, apte à réaliser une conversion des M échantillons numériques reçus en entrée depuis les N lignes de sortie de la mémoire et à délivrer successivement sur une sortie du convertisseur numérique-analogique chacun des M échantillons numériques convertis analogiquement formant ensemble un signal analogique représentatif de la forme d'onde.

Ainsi, le signal analogique obtenu peut être une impulsion codant numériquement une information dans une bande radio d'émission.

Avec l'invention, on génère numériquement une forme d'onde, de durée finie et pouvant être quantifiée, des impulsions à émettre et on la convertit analogiquement et rapidement, sans signal d'horloge. La génération de la forme d'onde numérique consiste à fournir les échantillons de la forme d'onde instantanée du signal à émettre en temps réel. L'invention est particulièrement avantageuse lorsque l'on utilise plusieurs échantillons numériques, c'est-à-dire lorsque l'on a M > 1 pour réaliser la forme d'onde. Il est ainsi possible d'obtenir quasiment instantanément une forme d'onde réalisée à partir de nombreux échantillons.

La ligne à retards, pouvant être réalisée à partir de circuits logiques, commande une mémoire très rapide dans laquelle il n'y a pas de décodage d'adresse. Ce dispositif émetteur permet de se passer d'une horloge de cadencement pour délivrer les échantillons numériques, qui devrait avoir une fréquence élevée (par exemple environ 10 GHz).

La lecture de la mémoire à très grande vitesse permet de générer un flot de données numériques qui est converti, par exemple en temps réel, par un convertisseur numérique-analogique. Le signal ainsi produit est amplifié afin d'être émis par exemple vers une antenne.

Un avantage pratique de cette invention est la possibilité de faire varier facilement la fréquence de la forme d'onde numérique grâce à l'utilisation de la ligne à retards, la fréquence de la forme d'onde numérique étant liée directement à la fréquence des signaux retardés, c'est-à-dire au retard élémentaire de la ligne à retards. On obtient ainsi un effet équivalent à la modification de la fréquence porteuse d'un générateur d'impulsion de l'art antérieur. Cet avantage est particulièrement utile dans le cas de systèmes de transmission multi-bandes pour lesquels l'émetteur doit être capable de passer facilement et rapidement d'une bande de fréquences à une autre tout en conservant la forme des impulsions émises.

De plus, de part la conception de l'invention, il n'y a pas de fuite possible de porteuse au niveau de la sortie du dispositif émetteur conduisant à l'émission d'un signal parasite préjudiciable. Avec le dispositif émetteur selon l'invention, lorsque aucun signal n'est émis, les échantillons numériques de la forme d'onde peuvent avoir une valeur nulle et le convertisseur numérique-analogique, fonctionnant de manière asynchrone, ne génère aucun signal parasite.

De manière générale, le dispositif émetteur selon l'invention fonctionne de manière asynchrone, permettant de réduire sa consommation électrique par rapport aux dispositifs émetteurs de l'art antérieur nécessitant un signal d'horloge pour leur fonctionnement. Le dispositif émetteur selon l'invention permet d'atteindre par exemple des consommations moyennes inférieures à environ 1 mW.

Par rapport aux dispositifs émetteurs de l'art antérieur comportant des générateurs d'onde sans porteuse, le dispositif émetteur selon l'invention dispose d'une grande flexibilité et d'une grande diversité au niveau des formes d'ondes pouvant être générées dans la mesure où la mémoire du dispositif émetteur selon l'invention peut stocker plusieurs formes d'onde différentes et que le contenu de la mémoire peut être aisément modifié, permettant de changer facilement la forme de l'onde à émettre.

La ligne à retards peut comporter au moins M cellules de retard reliées en série les unes aux autres, chaque cellule de retard étant apte à appliquer un retard à un signal entrant dans cette cellule et à délivrer à la mémoire ledit signal entrant et retardé en tant qu'un des M signaux retardés.

Les retards appliqués par les cellules de retard entre deux signaux consécutifs parmi les M signaux retardés peuvent être sensiblement similaires.

Chaque cellule de retard peut comporter au moins une entrée de commande, la durée du retard appliqué par chacune des cellules de retard pouvant dépendre d'une tension ou d'un courant de commande appliqué sur l'entrée de commande de ladite cellule de retard.

La ligne à retards peut comporter au moins une boucle à verrouillage de retard.

Les M échantillons numériques de la forme d'onde peuvent être stockés séquentiellement dans la mémoire, sans adressage.

La mémoire peut comporter en outre M portes ET logiques aptes à réaliser une opération logique ET entre un des M signaux retardés et un autre des M signaux retardés inversé, ces deux signaux retardés pouvant être deux signaux délivrés consécutivement.

Chaque élément de stockage peut comporter au moins deux inverseurs bouclés l'un avec l'autre et au moins deux transistors MOS, chaque transistor MOS étant relié respectivement à une entrée d'un des inverseurs, les grilles des transistors MOS de N éléments de stockage se trouvant sur une même colonne étant reliées à la sortie d'une des M portes ET logiques de la mémoire.

Chaque élément de stockage peut comporter au moins une bascule et une porte ET logique, une entrée de chacune desdites portes ET logiques des N éléments de stockage se trouvant sur une même colonne étant reliée à la sortie d'une des M portes ET logiques de la mémoire, une autre entrée de chacune desdites portes ET logiques étant reliée à la sortie de ladite bascule se trouvant dans le même élément de stockage que ladite porte ET logique.

Chaque élément de stockage peut comporter au moins une bascule et une porte ET logique, une entrée de chacune desdites portes ET logiques des N éléments de stockage se trouvant sur une même colonne étant apte à recevoir l'un des M signaux retardés, une autre entrée de chacune desdites portes ET logiques étant reliée à la sortie de ladite bascule se trouvant dans le même élément de stockage que ladite porte ET logique.

Des sorties de M portes ET logiques d'une ligne de M éléments de stockage peuvent être reliées à au moins M entrées d'une porte OU logique et/ou d'une porte OU exclusif logique.

Le dispositif émetteur peut comporter en outre une seconde mémoire, dans laquelle sont stockés des échantillons numériques d'une pluralité de formes d'ondes, reliée à l'autre mémoire, le dispositif émetteur pouvant être apte à transférer des échantillons numériques d'au moins l'une de la pluralité de formes d'ondes stockés de la seconde mémoire dans l'autre mémoire.

La mémoire peut être apte à stocker les M échantillons numériques de la forme d'onde à partir d'un fichier de données.

Une des N entrées du convertisseur numérique-analogique sur laquelle est destinée à être délivré un n-ième bit des échantillons numériques peut être reliée à un n-ième amplificateur pouvant comporter au moins $2^n$ inverseurs CMOS connectés en parallèle.

La puissance du signal émis par le dispositif émetteur peut être facilement ajustée à partir du convertisseur numérique-analogique.

Le convertisseur numérique-analogique peut comporter au moins N entrées, N étant le nombre de bits d'un des échantillons numériques, une entrée sur laquelle est destinée à être délivré un n-ième bit d'amplitude des échantillons numériques pouvant être reliée à au moins deux portes ET logiques reliées respectivement à deux n-ièmes amplificateurs réalisés à partir de $2^n$ inverseurs CMOS connectés en parallèle, une entrée sur laquelle est destinée à être délivré un bit de signe des échantillons numériques pouvant être reliée à toutes lesdites portes ET logiques du convertisseur numérique-analogique.

Une des N entrées du convertisseur numérique-analogique sur laquelle est destinée à être délivré un n-ième bit d'amplitude des échantillons numériques peut être reliée à au moins deux portes ET logiques pouvant être reliées respectivement à deux n-ièmes amplificateurs réalisés à partir de $2^n$ inverseurs CMOS connectés en parallèle, une des N entrées du convertisseur numérique analogique sur laquelle est destinée à être délivré un bit de signe des échantillons numériques pouvant être reliée à toutes lesdites portes ET logiques du convertisseur numérique-analogique.

Le convertisseur numérique-analogique peut comporter en outre des condensateurs destinés à filtrer le signal analogique.

Le dispositif émetteur peut comporter en outre des moyens d'amplification du signal analogique obtenu en sortie du convertisseur numérique-analogique. Ces moyens d'amplification peuvent par exemple être un amplificateur de puissance large bande, réalisant une amplification dans la bande de fréquences du signal destiné à être émis par le dispositif émetteur.

Les moyens d'amplification peuvent réaliser également un filtrage du signal analogique obtenu en sortie du convertisseur numérique-analogique.

Le dispositif émetteur peut également comporter au moins un transformateur, tel un transformateur de type balun, apte à recevoir en entrée le signal analogique.

Le dispositif émetteur peut comporter en outre des moyens de filtrage du signal analogique obtenu en sortie du convertisseur numérique-analogique ou des moyens de filtrage du signal analogique tels qu'une sortie des moyens d'amplification soit reliée à une entrée des moyens de filtrage.

Le signal analogique peut être un signal de fréquence comprise entre environ 1 GHz et 10 GHz, et/ou peut comporter au moins une impulsion de type à bande ultra large (UWB), et/ou peut comporter au moins une salve d'impulsions conforme à la norme IEEE 802.15.4a.

Avec le dispositif émetteur selon l'invention, il est possible de générer des salves (« burst » en anglais) d'impulsions selon la norme IEEE 802.15.4a, les impulsions d'une salve n'étant alors séparées que de 2 ns les unes des autres et produisant leur chevauchement, en particulier avec des impulsions de type cosinus surélevé (« root raised cosine » en anglais).

Il est proposé également un procédé d'émission de signaux, comportant au moins les étapes consistant à :

- réaliser M signaux retardés les uns par rapport aux autres, M étant un entier non nul,
- délivrer M échantillons numériques mémorisés d'une forme d'onde, chacun des échantillons étant délivré par la commande d'un des M signaux retardés,
- convertir analogiquement les M échantillons numériques de la forme d'onde, le signal analogique obtenu étant un signal analogique conforme à la forme d'onde.

Chacun des M signaux retardés peut comporter au moins un signal échelon, et/ou un front montant ou descendant, et/ou un signal d'horloge.

L'invention concerne en outre un procédé d'émission de signaux, comportant au moins les étapes consistant à :

- réaliser M signaux retardés les uns par rapport aux autres, M étant un entier supérieur à 1,
- délivrer M échantillons numériques mémorisés d'une forme d'onde, chacun des échantillons comportant N bits et étant successivement délivré sur N lignes de sorties (114) respectivement par la commande d'un des M signaux retardés (12.1 à 12.7),
- convertir analogiquement les M échantillons numériques et à délivrer successivement sur une sortie chacun des M échantillons numériques convertis analogiquement formant ensemble un signal analogique représentatif de la forme d'onde.

Les M signaux retardés peuvent être obtenus à partir d'un signal d'horloge de période Tref, un i-ème signal parmi les M signaux retardés comportant le signal d'horloge retardé d'un retard sensiblement égal à $Td_i = i \times Td_0$, avec

$$Td_0 = \frac{Tref}{j},$$ j étant un nombre réel non nul définissant le retard élémentaire $Td_0$ par rapport à Tref.

Les M échantillons numériques mémorisés peuvent être délivrés à la fréquence d'échantillonnage de l'onde formée par les échantillons numériques.

Le procédé d'émission peut comporter en outre, après l'étape de conversion analogique, une étape de filtrage et/ou une étape d'amplification.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un schéma de principe d'un dispositif émetteur, objet de la présente invention,
- la figure 2 représente un schéma de principe d'une ligne à retards d'un dispositif émetteur, objet de la présente invention,
- les figures 3A à 3C représentent des exemples de réalisation d'une cellule de retard utilisée dans une ligne à retards,
- la figure 4 représente la propagation d'un signal de déclenchement dans une ligne à retards d'un dispositif émetteur, objet de la présente invention,
- la figure 5 représente un schéma de principe d'une mémoire d'un dispositif émetteur, objet de la présente invention,
- les figures 6 à 8 représentent des exemples de réalisation de deux éléments de stockage respectivement de deux colonnes successives x et x+1 d'éléments de stockage d'une mémoire,
- les figures 9 et 10 représentent des exemples de réalisation d'un convertisseur numérique-analogique d'un dispositif émetteur, objet de la présente invention,
- la figure 11 représente des signaux obtenus en sortie de différents éléments d'un dispositif émetteur, objet de la présente invention, lors de l'émission d'un signal,
- les figures 12 et 13 représentent un dispositif émetteur, objet de la présente invention, respectivement selon un premier et un second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

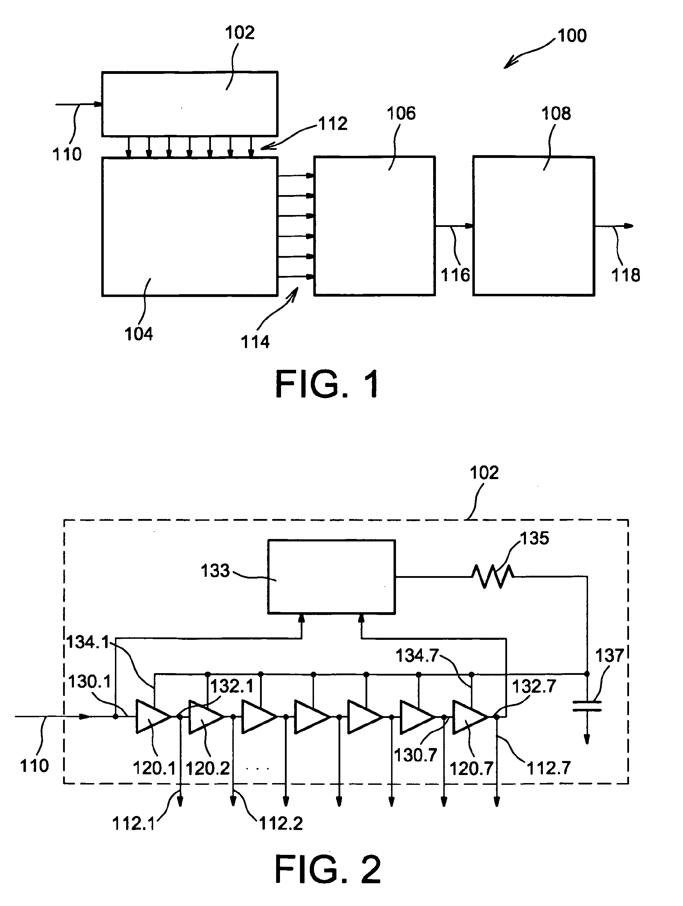

On se réfère tout d'abord à la figure 1 qui représente un schéma de principe d'un dispositif émetteur 100, destiné ici à émettre des impulsions par exemple de type UWB.

L'émetteur 100 comporte une ligne à retards 102. Cette ligne à retards 102, détaillée sur la figure 2, comporte ici M cellules élémentaires de retard reliées en série les unes aux autres, M correspondant au nombre d'échantillons numériques de l'impulsion à émettre. Sur la figure 2, la ligne à retards 102 comporte sept cellules de retard 120.1 à 120.7. Des sorties 132.1 à 132.7 de chaque cellule de retard 120.1 à 120.7 forment des sorties 112.1 à 112.7 de la ligne à retards 102.

Un signal de déclenchement, sous forme d'un signal d'horloge de période Tref et formant un échelon à chaque période du signal d'horloge, est appliqué sur une entrée 110 de la ligne à retards 102. Cette entrée 110 est reliée à une entrée 130.1 de la première cellule de retard 120.1. Le signal d'horloge appliqué sur l'entrée 130.1 est propagé dans la première cellule 120.1, puis est délivré sur la sortie 132.1 de la première cellule 120.1, qui est reliée à la première sortie 112.1 de la ligne à retards 102, avec un retard Td inférieur à la période du signal d'horloge Tref. La sortie 132.1 de la première cellule 120.1 est également reliée à une entrée de la seconde cellule 120.2. Le signal obtenu en sortie de la seconde cellule 120.2, c'est à dire également sur la seconde sortie 112.2 de la ligne à retards 102, est donc retardé du temps de retard Td appliqué par la première cellule 120.1 plus le temps de retard Td appliqué par la seconde cellule 120.2. Le temps de propagation du signal entre l'entrée et la sortie de chaque cellule de retard 120.1 à 120.7, c'est-à-dire le temps de retard Td de chacune de ces cellules, dépend d'une tension ou d'un courant de commande appliqué sur des entrées de commande 134.1 à 134.7 des cellules 120.1 à 120.7. Sur l'exemple de la figure 2, il s'agit d'une tension de commande. Les temps de retard Td de chacune des cellules de retard peuvent être sensiblement similaires les uns aux autres et être tels que Tref = M x Td. Ainsi, on obtient sur chacune des sorties 112.1 à 112.7 de la ligne à retards 102 de la figure 2 le signal d'horloge appliqué sur l'entrée 110 retardé d'un multiple de Td, tel que par exemple Tref = 7 * Td. Le i-ème signal obtenu sur la sortie 112.i de la ligne à retards 102 est donc le signal d'horloge appliqué sur l'entrée 110 retardé d'un retard sensiblement égal à $Td_i = i \times Td_0$, avec $Td_0 = \dfrac{Tref}{j}$ , j étant un nombre réel non nul définissant le retard élémentaire $Td_0$ par rapport à Tref.

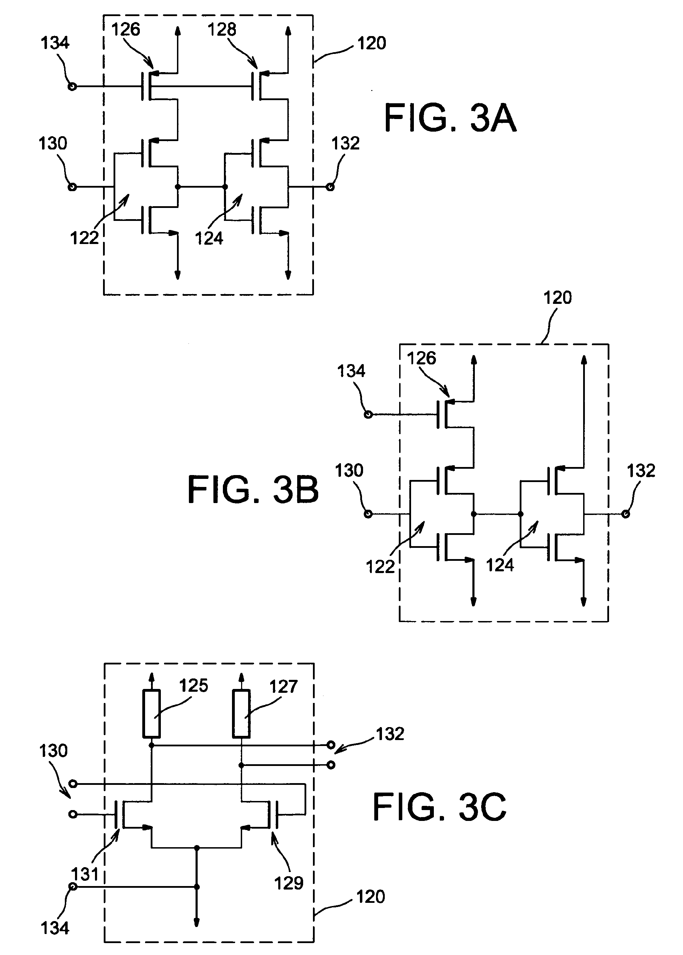

Les cellules de retard 120.1 à 120.7 peuvent être réalisées de plusieurs manières. Les figures 3A à 3C représentent chacune des exemples de réalisation d'une cellule de retard 120.

La cellule 120 de la figure 3A comporte deux inverseurs MOS 122 et 124 reliés en série. La cellule 120 comporte également deux transistors MOS, respectivement 126 et 128, chacun étant relié à un des inverseurs MOS, respectivement 126 et 128, afin de limiter en partie le courant de commutation des inverseurs 122 et 124 en fonction d'une tension de commande Vcom appliquée sur la grille des transistors 126 et 128 par l'intermédiaire d'une entrée de commande 134. Le signal appliqué sur une entrée 130 de la cellule 120 est donc inversé deux fois par les inverseurs 126 et 128, le signal obtenu sur la sortie 132 étant de valeur similaire à la valeur de départ, mais retardé du temps nécessaire pour réaliser les deux inversions.

La cellule 120 de la figure 3B comporte également deux inverseurs MOS 122 et 124, mais seul l'inverseur MOS 122 est relié à un transistor MOS 126. Donc, dans la cellule 120 de la figure 3B, seuls les fronts descendants du signal propagé dans la cellule 120 sont retardés, tandis que dans la cellule 120 de la figure 3A, les fronts descendants et montants du signal propagé dans la cellule 120 sont retardés.

Avec la cellule de retard 120 de la figure 3C, les signaux d'entrée et de sortie de la cellule 120 sont différentiels. Dans cette cellule, le temps de retard dépend d'un courant de commande Icom appliqué en permanence sur une entrée de commande 134 de la cellule 120. La cellule de retard 120 de la figure 3C comporte deux transistors NMOS 129 et 131, les sources de ces deux transistors NMOS 129 et 131 étant reliées entre elles et à l'entrée de commande 134. Chaque borne de l'entrée différentielle 130 est reliée respectivement à une grille d'un des transistors NMOS 129 et 131. Chaque drain des transistors NMOS 129 et 131 est relié respectivement à une charge 125 et 127, comportant chacune au moins un condensateur qui réalise un filtrage déphaseur en sortie, qui est fonction du courant de source. La sortie 132 est prise de manière différentielle entre les drains des transistors NMOS 129 et 131. La cellule de retard 120 de la figure 3C a une vitesse de fonctionnement supérieure à celles des figures 3A et 3B.

La ligne à retard 102 représentée sur la figure 2 comporte également un asservissement de type DLL (« Delay Locked Loop » en anglais, ou boucle à verrouillage de retard). Le signal de déclenchement, c'est-à-dire l'horloge de référence de période Tref, est utilisé pour asservir les retards élémentaires Td des cellules 120.1 à 120.7 de telle façon que Tref = 7 × Td. Cet asservissement est réalisé par un comparateur de phase 133 permettant de mesurer l'erreur de phase qui peut se produire, celle-ci étant ensuite filtrée par un filtre passe-bas, formé sur la figure 2 par une résistance 135 et un condensateur 137, ou un intégrateur afin de générer la tension ou le courant de commande des retards élémentaires.

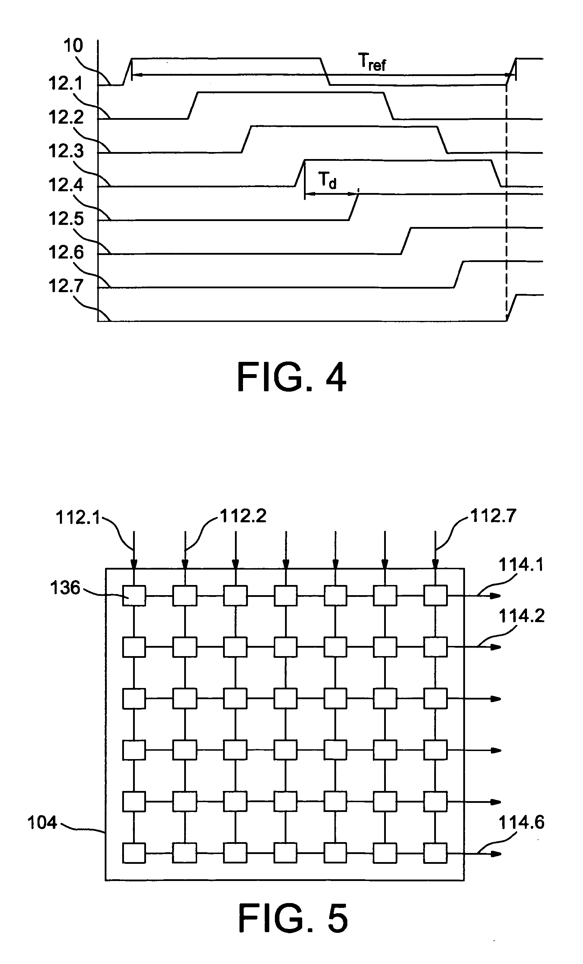

La figure 4 représente la propagation du signal de déclenchement dans la ligne à retards 102 de la figure 2. Un signal 10 représente l'horloge de période Tref appliquée sur l'entrée 110 de la ligne à retards 102. Les signaux 12.1 à 12.7 représentent respectivement les signaux obtenus sur les sorties 112.1 à 112.7 de la ligne à retards 102. On voit sur la figure 4 que chacun des signaux 12.1 à 12.7 comporte le signal d'horloge appliqué en entrée et retardé successivement d'une durée Td supplémentaire par rapport au signal précédent. Etant donné que Tref = M × Td, avec M = 7 (7 cellules de retard) dans le cas de la ligne à retards 102 de la figure 2, le signal 12.7 obtenu sur la dernière sortie 112.7 de la ligne à retards 102 correspond au signal d'horloge 10 retardé d'une durée égale à Tref, un premier front montant du signal 12.7 étant en phase avec un second front montant du signal d'horloge 10.

La ligne à retard 102 fournit autant de signaux retardés qu'il y a de cellules de retard. Les signaux issus de la ligne à retards 102 peuvent éventuellement être recombinés ensuite entre eux pour créer des impulsions de largeur Td plutôt que des échelons.

L'émetteur 100 comporte également une mémoire 104 dans laquelle sont mémorisés des échantillons numériques de l'impulsion UWB à générer. Sur la figure 1, on voit que les sorties 112 de la ligne à retards 102 sont appliquées en entrée de la mémoire 104. La fréquence de lecture des échantillons est égale à la fréquence d'échantillonnage de l'impulsion destinée à être formée par les échantillons, par exemple environ 10 GHz. Cette lecture des échantillons est réalisée par la mémoire 104 sans décodage d'adresse, la vitesse de lecture étant alors supérieure à celle d'une lecture avec décodage d'adresse. Les échantillons sont lus séquentiellement dans la mémoire 104, et non aléatoirement.

La figure 5 représente de façon schématique la mémoire 104 de l'émetteur 100. Cette mémoire 104 comporte ici M colonnes de N éléments de stockage 136, M correspondant au nombre d'échantillons mémorisés de l'impulsion utilisés pour représenter cette impulsion en fonction du temps et N correspondant au nombre de bits d'un des échantillons mémorisés. Sur l'exemple de la figure 5, une impulsion mémorisé dans la mémoire 104 est représentée par M = 7 échantillons de N = 6 bits chacun. Cette mémoire 104 reçoit en entrée les sorties 112.1 à 112.7 de la ligne à retards 102. Dès qu'un signal d'horloge se propage sur une des entrées 112.1 à 112.7, la colonne des éléments de stockage 136 reliés à cette entrée délivre sur N = 6 lignes de sorties 114.1 à 114.6 les 6 bits de l'échantillon stocké dans ladite colonne d'éléments de stockage 136, avec 1 bit sur chaque ligne de sortie 114.1 à 114.6.

Ainsi, dans l'exemple de réalisation de l'émetteur 100 décrit, un premier signal d'horloge, correspondant par exemple au signal 12.1 de la figure 4, se propage dans l'entrée 112.1. Les six éléments mémoire 136 de la colonne reliés à cette entrée 112.1 délivrent les six bits du premier échantillon sur les sorties 114.1 à 114.6. Puis, après une durée égale à Td, un second signal d'horloge, correspondant au signal 12.2 de la figure 4, se propage dans l'entrée 112.2. Les six éléments mémoire 136 de la colonne reliés à cette entrée 112.2 délivrent les six bits du second échantillon sur les sorties 114.1 à 114.6. L'opération se répète jusqu'à ce qu'un signal, correspondant au signal 12.7 de la figure 4, se propage sur la dernière entrée 112.7, les six éléments mémoire 136 de la dernière colonne reliés à cette entrée 112.7 délivrant les six bits du septième et dernier échantillon de l'impulsion mémorisée. L'opération est ensuite répétée en repartant de la première colonne.

Les échantillons mémorisés de l'impulsion sont donc lus sur une période égale à Tref correspondant à la période du signal d'horloge appliqué en entrée de la ligne à retards 102. La ligne à retards 102 commande donc directement les colonnes d'éléments de stockage 136 de la mémoire 104 dans le sens allant de la colonne 112.1 vers la colonne 112.7.

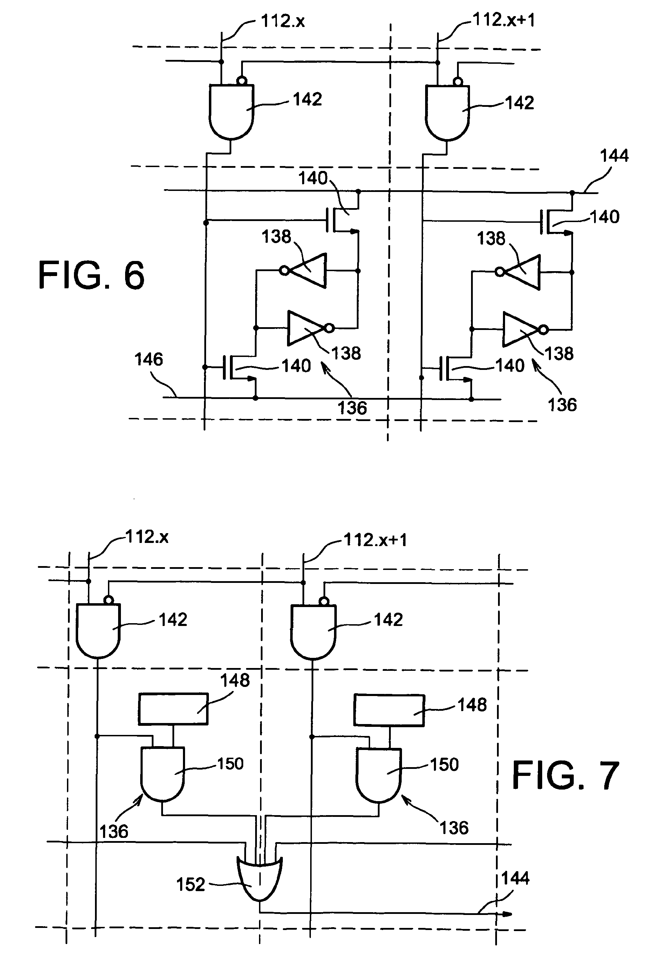

Dans ce mode de réalisation, la mémoire 104 comporte des éléments de stockage 136 statiques. La figure 6 représente un exemple de réalisation de deux éléments de stockage 136 de deux colonnes successives x et x+1 de la mémoire 104, avec ici 1 ≤ x ≤ 6. Dans l'exemple de la figure 6, les éléments de stockage 136 sont chacun formés de deux inverseurs 138 rebouclés l'un avec l'autre qui sont lus par l'intermédiaire de deux transistors MOS 140 reliés respectivement à une entrée des inverseurs 138. Ces transistors 140 sont commandés au niveau de leurs grilles par une impulsion formée sur chaque colonne par une porte ET logique 142, réalisant, par exemple pour une porte ET logique 142 de la colonne x, l'opération ET entre le signal appliqué sur une entrée 112.x de la colonne x et le signal inverse du signal appliqué sur une entrée 112.x+1 de la colonne x+1. Dans l'exemple de réalisation décrit, les signaux de la figure 4 appliqués sur les entrées 112.1 à 112.7 étant tous retardés d'un retard Td identique, le signal généré en sortie d'une des M portes ET logique 142 est une impulsion commençant sur le front montant du signal d'horloge se propageant sur l'entrée 112 correspondante et se terminant sur le front montant du signal d'horloge se propageant dans la colonne suivante. Chacune des sorties 114.1 à 114.6 de la mémoire 104 peut être reliée à une ligne 144 sur laquelle sont délivrés les bits lus d'une des N lignes de la mémoire 104 ou sur une ligne 146 sur laquelle est délivré le signal complémentaire des bits lus d'une des N lignes de la mémoire 104.

Sur l'exemple de réalisation des éléments de stockage 136 de la figure 6, chaque sortie 114 de la mémoire 104 est donc reliée en permanence à M transistors dont un seul est passant (celui en lecture). Pour augmenter la vitesse de lecture des éléments de stockage 136, on diminue l'impédance série des transistors 140.

La figure 7 représente un autre exemple de réalisation d'éléments de stockage 136 réalisés sans transistor MOS. Par rapport à l'exemple de réalisation de la figure 6, la valeur binaire de chaque élément de stockage 136 est ici stockée dans une bascule 148. Chaque élément de stockage 136 comporte une porte ET logique 150 réalisant un ET logique entre le signal de sortie de la porte ET logique 142 (émettant l'impulsion commandant la lecture de la valeur de l'élément de stockage) et la valeur stocké dans la bascule 148. En sortie de cette porte ET logique 150 on obtient la lecture de l'élément de stockage (0 ou 1 pendant une durée égale à Td). Tous les signaux de sortie des portes ET logiques 150 d'une même ligne sont amenés à une porte OU logique 152 comportant M entrées, réalisant sur la ligne de sortie 144 la même opération logique que celle obtenue sur la ligne de sortie 144 de l'exemple de la figure 6. Dans cette solution, la lecture se faisant par l'intermédiaire de portes logiques, les signaux sont propagés plus rapidement que dans une mémoire classique. De préférence, les temps de propagations sont partout identiques dans tous les éléments de stockage 136 et les impulsions de durée Td en sortie des portes ET logiques 142 ne se recouvrent pas.

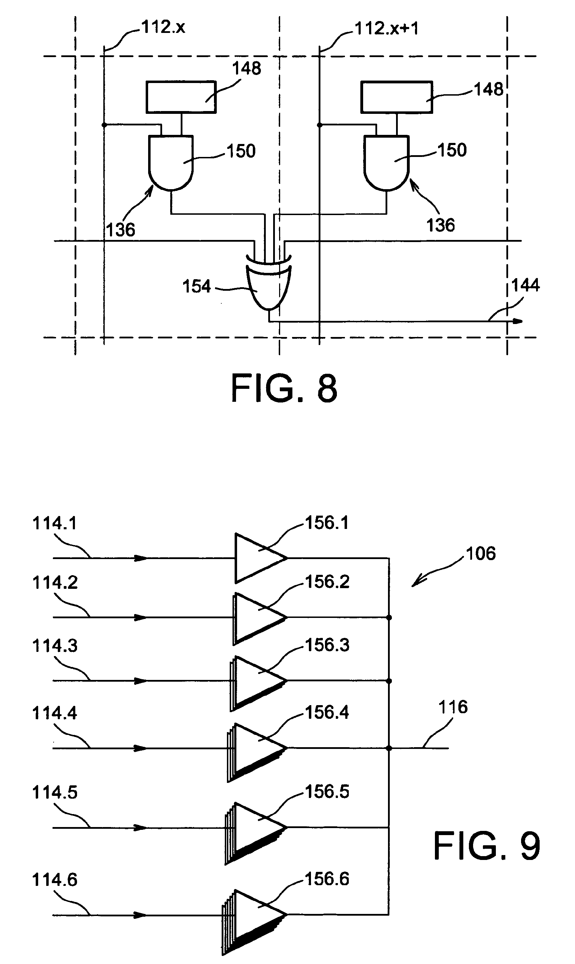

La figure 8 représente une autre variante de réalisation des éléments de stockage 136. Par rapport aux exemples de réalisation des figures 6 et 7, la mémoire 104 ne comporte pas les portes ET 142 permettant de réaliser les impulsions de commande de lecture à partir des signaux délivrés par la ligne à retards 102. Les signaux entrant dans la mémoire 104 par les entrées, ici 112.x et 112.x+1, sont directement traités en tant qu'entrée par les portes ET 150. De plus, la porte OU 152 de la figure 7 a été remplacée par une portes OU exclusif 154. La programmation des échantillons se fait donc ici de façon différentielle, chaque bit de donnée étant codé par rapport au précédent (le premier valant implicitement 0). Dans les échantillons stockés en mémoire, un 0 indique que la valeur ne change pas par rapport à la valeur précédente et un 1 indique que la valeur s'inverse. L'avantage de cette solution est de ne propager que les signaux émis de la ligne à retard 102.

On obtient donc en sortie de la mémoire 104 M échantillons numériques de l'impulsion destinée à être émise par l'émetteur 100 codés sur N bits.

Ces échantillons sont ensuite convertis analogiquement par le convertisseur numérique-analogique 106.

La figure 9 représente un exemple de réalisation du convertisseur numérique-analogique 106. La première sortie 114.1 de la mémoire 104, sur laquelle est délivré le bit 0 des échantillons de l'impulsion numérique, est reliée à l'entrée d'un premier amplificateur 156.1 réalisé par un inverseur CMOS. La seconde sortie 114.2, sur laquelle est délivré le bit 1 des échantillons de l'impulsion numérique, est reliée à l'entrée d'un second amplificateur 156.2 réalisé à partir de deux inverseurs CMOS connectés en parallèle. De manière générale, dans ce convertisseur, la sortie sur laquelle est délivré le n-ième bit est reliée à un n-ième amplificateur réalisé à partir de $2^n$ inverseurs CMOS connectés en parallèle. Ainsi, la sixième et dernière sortie 114.6 représentée sur la figure 9, sur laquelle est délivré le bit 5, est reliée à $2^5 = 32$ inverseurs CMOS 156.6 connectés en parallèles. Tous les inverseurs CMOS du convertisseur 106 sont ici identiques. Les inverseurs CMOS disposés en parallèle forment des amplificateurs équivalents plus ou moins gros suivant le poids binaire de chaque bit de donnée. Les inverseurs connectés en parallèle ont une dynamique de sortie en tension inchangée tandis que leurs impédances de sortie Z sont mises en parallèle. Ainsi, l'impédance de l'amplificateur n vaut $Z(n) = Z/2^n$. En reliant les sorties de tous les amplificateurs, on obtient, sur une sortie 116 du convertisseur 106, sur laquelle est reliée toutes les sorties des inverseurs CMOS du convertisseur 106, la somme Vs, pondérée d'un bit d'amplitude, des tensions V(n) issues de chaque amplificateur tel que :

$$Vs = \frac{\dfrac{V(0)}{Z} + \dfrac{2V(1)}{Z} + \dfrac{4V(2)}{Z} + ... + \dfrac{2^N V(N)}{Z}}{\dfrac{1}{Z} + \dfrac{2}{Z} + \dfrac{4}{Z} + ... + \dfrac{2^N}{Z}}$$

c'est-à-dire :

$$Vs = \frac{1}{2^N - 1} \sum_{n=0}^{N} 2^n . V(n) \ .$$

Avec N le nombre de bits d'un des M échantillons numériques et V(n) la tension égale à 0 ou 1 en fonction de la valeur du n-ième bit d'un échantillon numérique appliqué en entrée de l'amplificateur n.

Avec ce convertisseur 106, à moins que son alimentation ne soit symétrique, par exemple entre deux tensions de signes opposés, la tension de sortie est toujours du même signe. Si un des bits codant l'impulsion est un bit de signe, celui-ci sera mis en poids le plus fort et Vs présentera alors un biais égale à environ la moitié de la tension d'alimentation en fonction de ce signe.

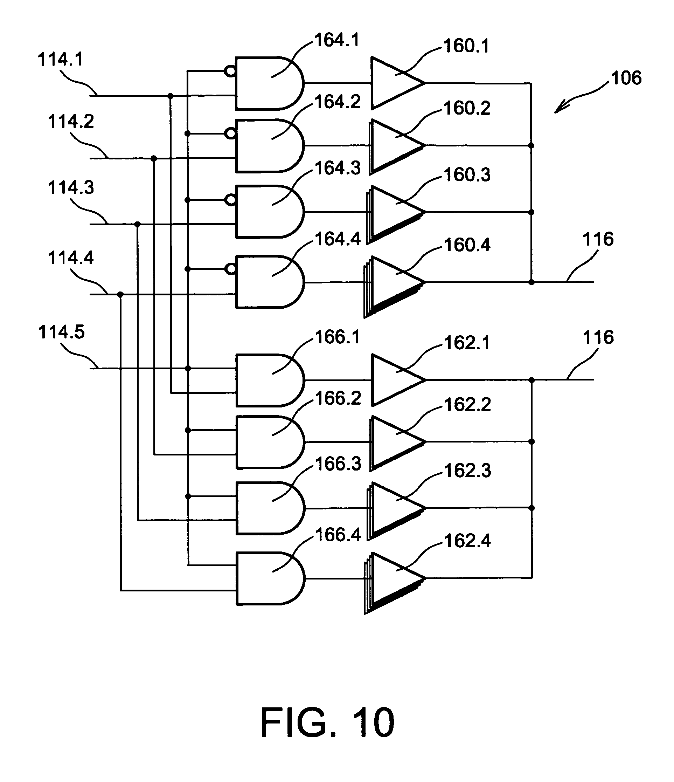

La figure 10 représente un second exemple de réalisation du convertisseur numérique-analogique 106 dans le cas où l'impulsion est codée avec un bit de signe sans codage particulier, et que la sortie Vs est différentielle. Dans ce second exemple de réalisation, la valeur de l'impulsion est ici considérée comme étant codée sur 5 bits de donnée, dont 1 bit de signe (émis sur la sortie 114.5). Toutefois, ce convertisseur 106 selon ce second mode de réalisation pourrait également être utilisé pour une conversion numérique-anaolgique d'une impulsion codée par un nombre de bits supérieur à 5. Le convertisseur 106 du second mode de réalisation comporte quatre premiers amplificateurs 160.1 à 160.4 réalisés à partir d'inverseurs CMOS, par exemple similaires aux amplificateurs 156.1 à 156.4 de la figure 9, ainsi que quatre seconds amplificateurs 162.1 à 162.4, par exemple similaires aux premiers amplificateurs 160.1 à 160.4.

Dans l'exemple de la figure 10, les premiers amplificateurs 160.1 à 160.4 permettent de convertir analogiquement l'impulsion lorsque celle-ci est de signe par exemple positif, les seconds amplificateurs 162.1 à 162.4 convertissant analogiquement l'impulsion lorsque celle-ci est de signe par exemple négatif.

Chacune des entrées des premiers amplificateurs 160.1 à 160.4 est reliée à la sortie d'une porte ET logique 164.1 à 164.4. De même, chacune des entrées des seconds amplificateurs 162.1 à 162.4 est reliée à la sortie d'une porte ET logique 166.1 à 166.4. Ces portes ET logique 164.1 à 164.4 et 166.1 et 166.4 permettent de forcer à zéro la sortie des amplificateurs utilisés pour une des deux polarités en fonction du bit de signe de l'impulsion.

Le signal converti analogiquement est obtenu de manière différentielle sur la sortie 116. Le signal Vs obtenu en sortie du convertisseur 106 selon ce second mode de réalisation est égale à :

$$Vs = \frac{2.S}{2^{N-1} - 1} \sum_{n=0}^{N-1} 2^n . V(n)$$

avec S le bit de signe pouvant prendre l'une des valeurs -1 ou +1, et N le nombre bits sur lesquels est codée numériquement l'impulsion (N-1 bits d'amplitude et 1 bit de signe).

Ce convertisseur numérique-analogique 106 selon ce second mode de réalisation permet d'obtenir un signal de sortie signé sans biais avec une alimentation asymétrique, et d'amplitude double par rapport au convertisseur numérique-analogique 106 du premier mode de réalisation représenté sur la figure 9.

Un autre exemple de convertisseur numérique-analogique utilisant la somme de courants commutés est également décrit dans le document US 6 985 532.

Tout convertisseur numérique-analogique peut convenir à l'invention à partir du moment où celui-ci peut fournir un signal de sortie dans la bande radio et en particulier de 1 à 10 GHz. Le convertisseur utilisé ici n'a pas besoin d'horloge pour son fonctionnement.

Si le convertisseur ne fournit pas la puissance d'émission nécessaire, un amplificateur, par exemple large bande, peut être inséré en sortie du convertisseur ainsi qu'un filtre pour supprimer du signal analogique les harmoniques générées par le convertisseur.

Dans l'exemple du dispositif émetteur 100 de la figure 1, la sortie 116 du convertisseur numérique-analogique 106 est reliée à l'entrée d'un filtre 108.

Le signal obtenu en sortie du convertisseur numérique-analogique 106 reste échantillonné et présente entre deux échantillons des transitions brutales indésirables. Ces transitions se situent à des fréquences supérieures aux fréquences du spectre du signal souhaité. Leur élimination et le lissage du signal peuvent être réalisés en faisant appel au filtrage parasite du convertisseur 106 et de la sortie 116, ou par le filtre 108 pouvant être un filtre coupe-haut ou passe-bande, coupant ainsi le plus possible les fréquences hautes tout en préservant le spectre du signal à émettre.

Si un amplificateur de puissance est utilisé avant l'émission du signal, celui-ci pourra être choisi de façon à filtrer naturellement la bande utile du signal, formant ainsi le filtre 108.

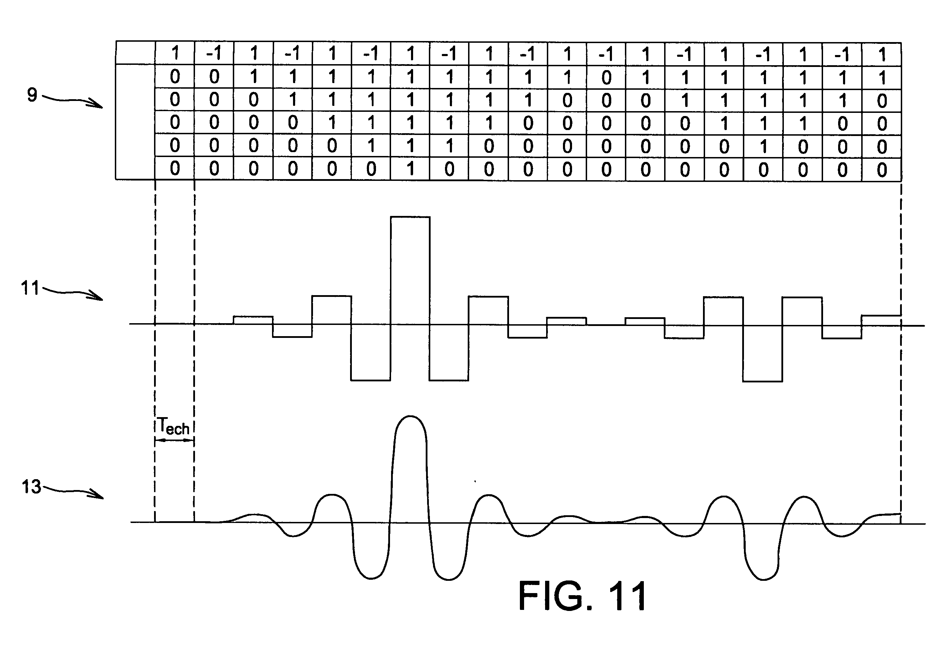

La figure 11 montre les différentes étapes de « construction » du signal à émettre, c'est-à-dire les signaux obtenus à différents endroits du dispositif émetteur 100. Le tableau 9 représente, dans chaque colonne, une valeur binaire de chaque échantillon de l'impulsion obtenu en sortie de la mémoire 104. La première ligne du tableau 9 représente le signe du signal. La courbe 11 est le signal obtenu en sortie du convertisseur numérique-analogique 106. La courbe 13 représente le signal obtenu en sortie du filtre 108. Ici, Tech représente la période d'échantillonnage de l'impulsion. Dans le cas de l'ultra large bande, la période d'échantillonnage Tech peut être de l'ordre de 100 ps. Le bit de signe est optionnel et peut par exemple être omis si le signal à générer est toujours du même signe.

Les théories de l'échantillonnage montrent que la génération de la forme d'onde numérique est réalisée à au moins deux fois la fréquence du signal qui doit être généré. Par exemple, si l'on souhaite émettre un signal de fréquence égale à 4 GHz, l'échantillonnage est réalisé au moins 8 Ge/s (échantillons par seconde). La conversion numérique-analogique est, quand à elle, capable de fournir des échantillons analogiques à la même cadence.

Le dispositif émetteur comporte également une antenne émettrice, non représenté sur la figure 1, reliée ici à la sortie 118 du filtre 108, permettant l'émission de la forme d'onde générée. Il est également possible que l'antenne soit reliée à la sortie 116 du convertisseur numérique-analogique 106 lorsque le dispositif émetteur 100 ne comporte pas le filtre 108.

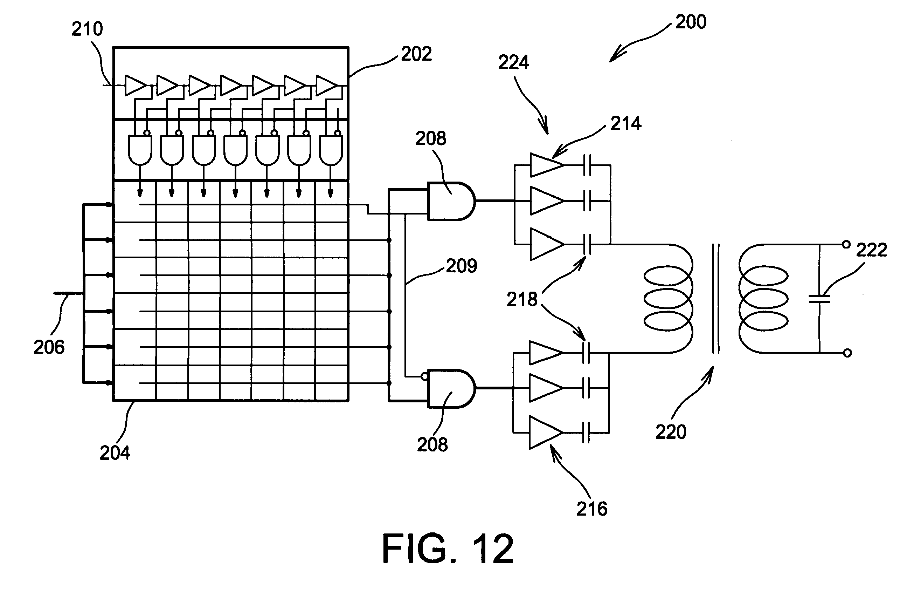

La figure 12 représente un dispositif émetteur 200 selon un premier mode de réalisation. Un signal de déclenchement est appliqué sur une entrée 210 d'une ligne à retards logique 202. La ligne à retards 202 permet de générer des signaux échelon avec autant de retards élémentaires Td qu'il y a de colonnes d'éléments de stockage dans une mémoire 204. Une porte ET logique associée à chaque cellule retard de la ligne à retards 202 construit à partir de ces échelons une impulsion carrée dont la largeur correspond à un retard Td et qui se propage d'une cellule à l'autre au rythme de Td. Il faut noter que la ligne à retards 202 peut être bouclée de façon à faire varier et à asservir Td sur une horloge de référence et former ainsi une « Boucle à verrouillage de retards » (DLL). Td représente aussi le pas temporel équivalent des échantillons. La faible consommation électrique d'une ligne à retards, bouclée ou non, est un avantage par rapport à une PLL par exemple.

La forme d'onde de l'impulsion à générer est chargée dans la mémoire 204 par des entrées 206 avant que le signal de déclenchement ne se propage dans la ligne à retards 202. La sélection des données stockées dans la mémoire 204 représentant la forme d'onde ne se fait pas par adressage mais en colonne par l'intermédiaire d'une porte ET se trouvant dans chaque cellule mémoire de la mémoire 204. Ce ET logique est réalisé entre les impulsions issues de la ligne à retards 202 et les bits de la forme d'onde stockés dans la mémoire 204. Il en résulte une impulsion quand le bit stocké à un niveau logique « 1 » et rien lorsque le bit stocké à un niveau logique « 0 ». Grâce à l'opération OU réalisée entre toutes les cellules mémoire d'une ligne de la mémoire 204, la mémoire 204 fournit sur chaque ligne de sortie un bit du signal numérique généré. En d'autres termes, chaque bit est formé de la somme des impulsions issues de la ligne à retard modulées du motif de la forme d'onde stocké dans la ligne mémoire de ce bit. Par exemple, si le motif « 010101... » est chargé en mémoire, le résultat sera un signal de type horloge de période 2.Td.

Ce dispositif émetteur 200 peut potentiellement répéter la même forme d'onde pour chaque signal de déclenchement appliqué sur l'entrée 210. Cependant, dans le cas où le temps entre deux émissions le permet, la mémoire 204 peut être rechargée avec une nouvelle forme d'onde, mémorisé par exemple dans une autre mémoire reliée aux entrées 206 de la mémoire 204, non représentée sur la figure 12, pour l'impulsion suivante. Ainsi, on peut émettre des formes d'onde différentes pour plusieurs signaux de déclenchement appliqués sur l'entrée 210. De plus, la mémoire 204 peut également comporter un nombre d'éléments de stockage tel qu'il soit possible de mémoriser plusieurs formes d'onde dans cette mémoire 204.

Dans cet exemple de la figure 12, le signal numérique comporte N-1 bits d'amplitude et un bit de signe, mais il peut être codé de diverses façons conduisant à des types de convertisseurs numérique-analogique différents et, en particulier, à des convertisseurs différentiels ou non. Dans le cas d'un convertisseur numérique-analogique différentiel, le signal numérique obtenu en sortie de la mémoire 204 est séparé en deux signaux se trouvant en opposition de phase. Dans l'exemple du dispositif émetteur 200 de la figure 12, les bits d'amplitude sont sélectionnés par 2(N-1) portes ET 208 suivant la valeur du bit de signe propagé sur une ligne 209. Sur la figure 12, seules deux portes ET 208 son représentées. Les bits émis depuis la mémoire 204 sont ainsi fournis alternativement à des amplificateurs de puissance d'une polarité 214 ou de l'autre 216 suivant la valeur du bit de signe, ces amplificateurs 214 et 216 formant ici un convertisseur numérique-analogique différentiel 224. Il est également possible d'utiliser un convertisseur numérique-analogique non différentiel (avec un seul jeu d'amplificateurs par exemple) auquel serait présenté un signal sur des bits utilisant l'actuel bit de signe comme bit de poids fort.

Dans l'exemple de la figure 12, le convertisseur numérique-analogique différentiel 224 se base sur la somme pondérée en puissances de 2 du courant fourni par autant d'amplificateurs qu'il y a de bits d'amplitude. Les amplificateurs peuvent ici être des inverseurs logiques de taille suffisante pour la puissance à fournir. Les inverseurs CMOS, par exemple, ont l'avantage de ne consommer qu'un faible courant de fuite en l'absence de transition sur les signaux. Des condensateurs 218 sont reliés aux sorties des amplificateurs 214 et 216, permettant le filtrage du signal obtenu en sortie des amplificateurs 214 et 216.

La sortie du convertisseur numérique-analogique 224 est relié à un transformateur 220, par exemple de type balun, permettant de convertir les courants différentiels obtenus en sortie du convertisseur numérique-analogique 224 en un signal de sortie en tension, pouvant être référencé à la masse (signal non différentiel), et qui est filtré ensuite par un condensateur 222. En l'absence du transformateur 220, le signal serait ici de type différentiel et référencé à la moitié de la tension d'alimentation des amplificateurs.

Dans cet exemple de dispositif émetteur 200, celui-ci ne fait pas appel à une horloge d'échantillonnage et le convertisseur numérique-analogique 224 de cet émetteur 200 ne nécessite pas d'horloge.

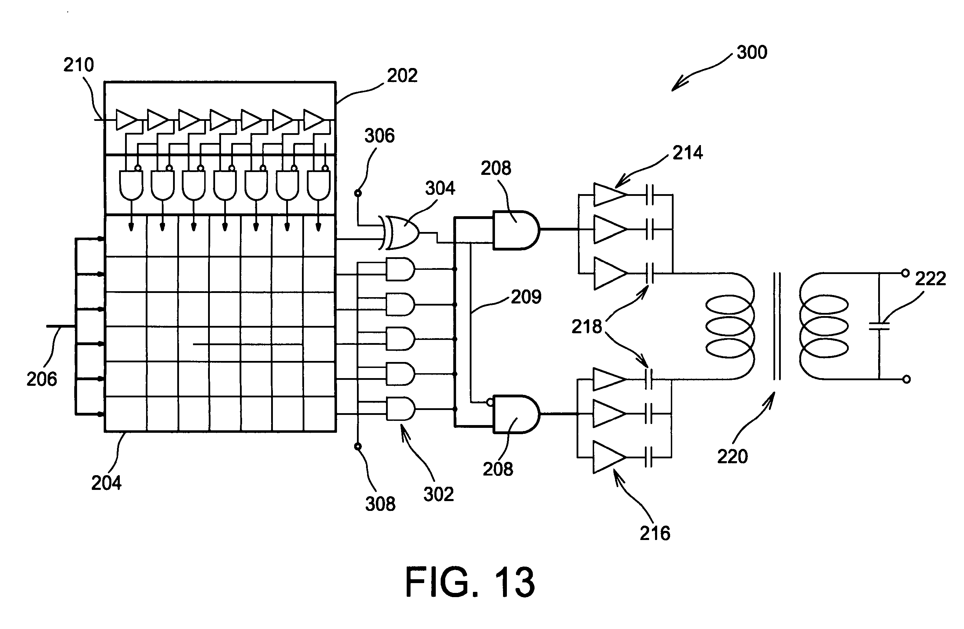

La figure 13 représente un dispositif émetteur 300 selon un second mode de réalisation. Par rapport au dispositif émetteur 200 de la figure 12, le dispositif émetteur 300 comporte des portes ET logiques 302 reliées aux sorties de la mémoire 204 sur lesquelles sont délivrés les bits d'amplitude de l'impulsion, ainsi qu'une porte OU exclusif 304 reliée à la sortie de la mémoire 204 sur laquelle est délivré le bit de signe de l'impulsion. Ainsi, il est possible de moduler l'impulsion en polarité, par exemple par une modulation BPSK (« Binary Phase Shift Keying » en anglais, ou modulation en phase binaire) ou DBPSK (« Differential Binary Phase Shift Keying » en anglais, ou modulation en phase binaire différentielle), sur toute la forme d'onde, à partir d'un signal de polarité appliqué sur une entrée 306 de la porte OU exclusif 304. Les portes ET 302 permettent d'activer et de désactiver la génération des impulsions par l'intermédiaire d'un signal d'activation appliqué sur une entrée 308 sur chacune des portes ET, sans avoir à charger une forme d'onde nulle dans la mémoire 204 et sans bloquer le signal de déclenchement de la ligne à retards 202 appliqué sur l'entrée 210 quand aucune impulsion ne doit être générée. On peut ainsi réaliser une modulation OOK (« On Off shift Keying » en anglais, ou modulation tout ou rien).

Ce dispositif émetteur 300 permet de simplifier la génération des impulsions, en particulier en évitant de devoir charger des formes d'onde dans la mémoire 204 quand il s'agit seulement de générer une forme d'onde de forme opposée ou une forme d'onde nulle.

Il est également possible d'utiliser un signal de déclenchement pour la ligne à retards 202 qui soit une horloge, et ainsi transformer la ligne à retards 202 en une boucle à verrouillage de retard (DLL).

Le dispositif émetteur selon l'invention peut par exemple être réalisé en composants intégrés sur un circuit de silicium.

L'invention peut être utilisée dans toutes les applications concernant les communications sans fil courte portée (quelques dizaines de mètres) de type UWB. Elle peut avantageusement remplacer les émetteurs existants et elle est compatible avec la norme IEEE 802.15.4a qui nécessite l'émission de salves d'impulsions.

L'invention possède également de nombreuses applications dans les domaines de la mesure de distance, la localisation ou encore la mesure de vitesse de déplacement d'un émetteur-récepteur. Les propriétés basse consommation permettent de réaliser des dispositifs portables alimentés par piles ou batterie. Dès lors, les applications peuvent être très variées dans des domaines tels que la télémétrie ou la surveillance du déplacement des personnes et des biens dans les locaux ou les transports.

**Revendications**

**1.** Dispositif émetteur (100, 200, 300), comportant au moins :

- une ligne à retards (102, 202) apte à délivrer M signaux (12.1 à 12.7) retardés les uns par rapport aux autres, M étant un entier supérieur à 1,
- une mémoire (104, 204), destinée à stocker au moins M échantillons numériques (9) d'une forme d'onde, chaque échantillon numérique (9) comportant N bits, et à délivrer successivement chacun des M échantillons numériques (9) sur N lignes de sorties (114), respectivement par la commande d'un des M signaux retardés (12.1 à 12.7),
- un convertisseur numérique-analogique (106, 224) comportant N entrées (114) reliées aux N lignes de sorties (114), apte à réaliser une conversion des M échantillons numériques (9) reçus en entrée depuis les N lignes de sortie (114) de la mémoire (104, 204) et à délivrer successivement sur une sortie (116) du convertisseur numérique-analogique (106, 224) chacun des M échantillons numériques (9) convertis analogiquement formant ensemble un signal analogique (11) représentatif de la forme d'onde.

**2.** Dispositif émetteur (100, 200, 300) selon la revendication 1, la ligne à retards (102, 202) comportant au moins M cellules de retard (120, 120.1 à 120.7) reliées en série les unes aux autres, chaque cellule de retard (120, 120.1 à 120.7) étant apte à appliquer un retard à un signal (130, 130.1 à 130.7) entrant dans cette cellule (120, 120.1 à 120.7) et à délivrer à la mémoire (104, 204) ledit signal entrant et retardé en tant qu'un des M signaux retardés (12.1 à 12.7).

**3.** Dispositif émetteur (100, 200, 300) selon la revendication 2, les retards appliqués par les cellules de retard (120, 120.1 à 120.7) entre deux signaux consécutifs parmi les M signaux retardés (12.1 à 12.7) étant sensiblement similaires.

**4.** Dispositif émetteur (100, 200, 300) selon l'une des revendications 2 ou 3, chaque cellule de retard (120, 120.1 à 120.7) comportant au moins une entrée de commande (134, 134.1 à 134.7), la durée du retard appliqué par chacune des cellules de retard (120, 120.1 à 120.7) dépendant d'une tension ou d'un courant de commande appliqué sur l'entrée de commande (134, 134.1 à 134.7) de ladite cellule de retard (120, 120.1 à 120.7).

**5.** Dispositif émetteur (100, 200, 300) selon la revendication 4, chaque cellule de retard (120) comportant en outre deux inverseurs MOS (122, 124) reliés en série et au moins un transistor MOS (126) relié à l'un des inverseurs MOS (122), l'entrée de commande (134) de chaque cellule de retard (120) étant reliée à une grille du transistor MOS (126) de cette cellule de retard (120).

**6.** Dispositif émetteur (100, 200, 300) selon la revendication 5, chaque cellule de retard (120) comportant en outre un second transistor MOS (128) relié à l'autre des inverseurs MOS (124), l'entrée de commande (134) de chaque cellule de retard (120) étant reliée à une grille du second transistor MOS (128) de cette cellule de retard (120).

**7.** Dispositif émetteur (100, 200, 300) selon l'une des revendications 2 à 4, chaque cellule de retard (120) comportant au moins deux transistors NMOS (129, 131), un drain de chaque transistor NMOS (129, 131) étant relié à une résistance (125, 127), l'entrée (130) de chaque cellule de retard (120) étant appliquée de manière différentielle entre les grilles des transistors NMOS (129, 131) et la sortie (132) de chaque cellule de retard (120) étant prise de manière différentielle entre les drains des transistors NMOS (129, 131).

**8.** Dispositif émetteur (100, 200, 300) selon l'une des revendications précédentes, la ligne à retards (102, 202) comportant au moins une boucle à verrouillage de retard.

**9.** Dispositif émetteur (100, 200, 300) selon la revendication 8, la boucle à verrouillage de retard comportant au moins un comparateur de phase (133) et un filtre passe-bas (135, 137).

**10.** Dispositif émetteur (100, 200, 300) selon l'une des revendications précédentes, les M échantillons numériques (9) de la forme d'onde étant stockés séquentiellement dans la mémoire (104, 204), sans adressage.

**11.** Dispositif émetteur (100, 200, 300) selon l'une des revendications précédentes, la mémoire (104, 204) comportant au moins M colonnes de N éléments de stockage (136), formant également N lignes de M éléments de stockage (136).

**12.** Dispositif émetteur (100, 200, 300) selon la revendication 11, la mémoire (104, 204) comportant en outre M portes ET logiques (142) aptes à réaliser une opération logique ET entre un des M signaux retardés et un autre des M signaux retardés inversé.

**13.** Dispositif émetteur (100, 200, 300) selon la revendication 12, chaque élément de stockage (136) comportant au moins deux inverseurs (138) bouclés l'un avec l'autre et au moins deux transistors MOS (140), chaque transistor MOS (140) étant relié respectivement à une entrée d'un des inverseurs (138), les grilles des transistors MOS (140) de N éléments de stockage (136) se trouvant sur une même colonne étant reliées à la sortie d'une des M portes ET logiques (142) de la mémoire (104, 204).

**14.** Dispositif émetteur (100, 200, 300) selon la revendication 12, chaque élément de stockage (136) comportant au moins une bascule (148) et une porte ET logique (150), une entrée de chacune desdites portes ET logiques (150) des N éléments de stockage (136) se trouvant sur une même colonne étant reliée à la sortie d'une des M portes ET logiques (142) de la mémoire (104, 204), une autre entrée de chacune desdites portes ET logiques (150) étant reliée à la sortie de ladite bascule (148) se trouvant dans le même élément de stockage (136) que ladite porte ET logique (150).

**15.** Dispositif émetteur (100, 200, 300) selon la revendication 11, chaque élément de stockage (136) comportant au moins une bascule (148) et une porte ET logique (150), une entrée de chacune desdites portes ET logiques (150) des N éléments de stockage (136) se trouvant sur une même colonne étant apte à recevoir l'un des M signaux retardés, une autre entrée de chacune desdites portes ET logiques (150) étant reliée à la sortie de ladite bascule (148) se trouvant dans le même élément de stockage (136) que ladite porte ET logique (150).

**16.** Dispositif émetteur (100, 200, 300) selon l'une des revendications 14 ou 15, des sorties de M portes ET logiques (150) d'une ligne de M éléments de stockage (136) étant reliées à au moins M entrées d'une porte OU logique (152) et/ou d'une porte OU exclusif logique (154).

**17.** Dispositif émetteur (200, 300) selon l'une des revendications précédentes, comportant en outre une seconde mémoire, dans laquelle sont stockés des échantillons numériques d'une pluralité de formes d'ondes, reliée à l'autre mémoire (204), le dispositif émetteur (200, 300) étant apte à transférer des échantillons numériques d'au moins l'une de la pluralité de formes d'ondes stockés de la seconde mémoire dans l'autre mémoire (204).

**18.** Dispositif émetteur (100, 200, 300) selon l'une des revendications précédentes, la mémoire (104, 204) étant apte à stocker les M échantillons numériques (9) de la forme d'onde à partir d'un fichier de données.

**19.** Dispositif émetteur (100, 200, 300) selon l'une des revendications précédentes, une des N entrées (114.1 à 114.6) du convertisseur numérique-analogique (106, 224) sur laquelle est destinée à être délivré un n-ième bit des échantillons numériques étant reliée à un n-ième amplificateur (156.1 à 156.6) comportant au moins $2^n$ inverseurs CMOS connectés en parallèle.

**20.** Dispositif émetteur (100, 200) selon l'une des revendications précédentes, le convertisseur numérique-analogique (106, 224) réalisant une opération de conversion selon l'équation :

$$Vs = \frac{1}{2^N - 1} \sum_{n=0}^{N} 2^n . V(n) \, ,$$

avec

   • Vs : tension du signal analogique obtenu en sortie du convertisseur,
   • V(n) : tension d'un n-ième bit d'un des M échantillons numériques.

**21.** Dispositif émetteur (100, 200, 300) selon l'une des revendications 1 à 18, une des N entrées (114.1 à 114.4) du convertisseur numérique-analogique (106, 224) sur laquelle est destinée à être délivré un n-ième bit d'amplitude des échantillons numériques étant reliée à au moins deux portes ET logiques (164.1 à 164.4, 166.1 à 166.4, 208) reliées respectivement à deux n-ièmes amplificateurs (160.1 à 160.4, 162.1 à 162.4, 214, 216) réalisés à partir de $2^n$ inverseurs CMOS connectés en parallèle, une des N entrées (114.5) du convertisseur numérique-analogique (106, 224) sur laquelle est destinée à être délivré un bit de signe des échantillons numériques étant reliée à toutes lesdites portes ET logiques (164.1 à 164.4, 166.1 à 166.4, 208) du convertisseur numérique-analogique (106, 224).

**22.** Dispositif émetteur (100, 300) selon l'une des revendications 1 à 18 ou 21, le convertisseur numérique-analogique (106, 224) réalisant une opération de conversion selon l'équation :

$$Vs = \frac{2.S}{2^{N-1} - 1} \sum_{n=0}^{N-1} 2^n . V(n) \, ,$$

avec

   • Vs : tension du signal analogique obtenu en sortie du convertisseur ;
   • S : bit de signe des échantillons numériques pouvant prendre l'une des valeurs -1 ou +1 ;
   • V(n) : tension d'un n-ième bit d'un des M échantillons numériques ;
   • N : nombre de bits d'un des M échantillons numériques (N-1 bits d'amplitude + 1 bit de signe).

**23.** Dispositif émetteur (200, 300) selon l'une des revendications précédentes, le convertisseur numérique-analogique (224) comportant en outre des condensateurs (218) destinés à filtrer le signal analogique (11).

**24.** Dispositif émetteur (300) selon l'une des revendications précédentes, comportant en outre une pluralité de portes ET logiques (302) reliées aux sorties de la mémoire (204) sur lesquelles sont délivrés N-1 bits d'amplitude des M échantillons numériques, et une porte OU exclusif (304) reliée à la sortie de la mémoire (204) sur laquelle est délivré un bit de signe des M échantillons numériques, les sorties desdites portes ET logiques (302) et de ladite porte OU exclusif (304) étant reliées au convertisseur numérique-analogique (224).

**25.** Dispositif émetteur (200, 300) selon l'une des revendications précédentes, comportant en outre au moins un transformateur (220), tel un transformateur de type balun, apte à recevoir en entrée le signal analogique (11).

**26.** Dispositif émetteur (100, 200, 300) selon l'une des revendications précédentes, comportant en outre des moyens d'amplification du signal analogique obtenu en sortie du convertisseur numérique-analogique (106).

**27.** Dispositif émetteur (100, 200, 300) selon la revendication 26, les moyens d'amplification réalisant également un filtrage du signal analogique obtenu en sortie du convertisseur numérique-analogique (106).

**28.** Dispositif émetteur (100) selon l'une des revendications 1 à 24, comportant en outre des moyens de filtrage (108) du signal analogique (10) obtenu en sortie du convertisseur numérique-analogique (106).

**29.** Dispositif émetteur (100) selon la revendication 26, comportant en outre des moyens de filtrage du signal analogique (10), une sortie des moyens d'amplification étant reliée à une entrée des moyens de filtrage.

**30.** Dispositif émetteur (100) selon l'une des revendications 28 ou 29, les moyens de filtrage (108) comportant au moins un filtre coupe-haut et/ou au moins un filtre passe-bande.

**31.** Dispositif émetteur (100, 200, 300) selon l'une des revendications précédentes, le signal analogique étant un signal de fréquence comprise entre environ 1 GHz et 10 GHz.

**32.** Dispositif émetteur (100, 200, 300) selon l'une des revendications précédentes, le signal analogique comportant au moins une impulsion de type à bande ultra large (UWB).

**33.** Dispositif émetteur (100, 200, 300) selon l'une des revendications précédentes, le signal analogique comportant au moins une salve d'impulsions conforme à la norme IEEE 802.15.4a.

**34.** Procédé d'émission de signaux, comportant au moins les étapes consistant à :

- réaliser M signaux retardés (12.1 à 12.7) les uns par rapport aux autres, M étant un entier non nul,
- délivrer M échantillons numériques mémorisés (9) de N bits d'une forme d'onde, chacun des échantillons (9) étant successivement délivré sur N lignes de sorties (114) respectivement par la commande d'un des M signaux retardés (12.1 à 12.7),
- convertir analogiquement les M échantillons numériques (9) et à délivrer successivement sur une sortie (116) chacun des M échantillons numériques (9) convertis analogiquement formant ensemble un signal analogique (11) représentatif de la forme d'onde.

**35.** Procédé d'émission selon la revendication 34, chacun des M signaux retardés (12.1 à 12.7) comportant au moins un signal échelon, et/ou un front montant ou descendant, et/ou un signal d'horloge.

**36.** Procédé d'émission selon l'une des revendications 34 ou 35, des retards entre deux signaux consécutifs parmi les M signaux retardés (12.1 à 12.7) étant sensiblement similaires.

**37.** Procédé d'émission selon la revendication 36, les M signaux retardés (12.1 à 12.7) étant obtenus à partir d'un signal d'horloge (10) de période Tref, un i-ème signal parmi les M signaux retardés (12.1 à 12.7) comportant le signal d'horloge (10) retardé d'un retard sensiblement égal à $Td_i = i \times Td_0$, avec $Td_0 = \dfrac{Tref}{j}$, j étant un nombre réel non nul définissant le retard élémentaire $Td_0$ par rapport à Tref.

**38.** Procédé d'émission selon la revendication 37, des retards des M signaux retardés (12.1 à 12.7) étant ajustés par une tension ou un courant de commande obtenu par la mesure d'une erreur de phase du signal d'horloge (10).

39. Procédé d'émission selon l'une des revendications 34 à 38, les M échantillons numériques (9) mémorisés étant délivrés à la fréquence d'échantillonnage de l'onde formée par les échantillons numériques (9).

40. Procédé d'émission selon l'une des revendications 34 à 39, la conversion analogique des M échantillons numériques (9) étant réalisée selon l'équation :

$$Vs = \frac{1}{2^N - 1} \sum_{n=0}^{N} 2^n . V(n) \, ,$$

avec

- Vs : tension du signal analogique obtenu,
- V(n) : tension d'un n-ième bit d'un des M échantillons numériques.

41. Procédé d'émission selon l'une des revendications 34 à 39, la conversion analogique des M échantillons numériques (9) étant réalisée selon l'équation :

$$Vs = \frac{2.S}{2^{N-1} - 1} \sum_{n=0}^{N-1} 2^n . V(n) \, ,$$

avec

- S : bit de signe des échantillons numériques pouvant prendre l'une des valeurs -1 ou +1,
- Vs : tension du signal analogique obtenu,
- V(n) : tension d'un n-ième bit d'un des M échantillons numériques,
- N : nombre de bits d'un des M échantillons numériques (N-1 bits d'amplitude + 1 bit de signe).

42. Procédé d'émission selon l'une des revendications 34 à 41, comportant en outre, après l'étape de conversion analogique, une étape de filtrage et/ou une étape d'amplification.

43. Procédé d'émission selon l'une des revendications 34 à 42, comportant en outre, après l'étape de délivrance des M échantillons numériques mémorisés (9), une étape de modulation des M échantillons numériques en polarité, telle une modulation BPSK, et/ou DBPSK et/ou OOK.

**Claims**

1. Transmitter device (100, 200, 300) which includes at least:

   - one delay line (102, 202) designed to output M signals (12.1 to 12.7) which are delayed in relation to each other, where M is an integer greater than 1,
   - a memory (104, 204), designed to store at least M digital samples (9) of a wave-form, where each digital sample (9) comprises N bits, and to output each of the M digital samples (9) successively over N output lines (114) respectively, under the control of one of the M delayed signals (12.1 to 12.7),
   - a digital-analog converter (106, 224) which includes N inputs (114) linked to N output lines (114), designed to convert the M digital samples (9) received as input from the N output lines (114) of the memory (104, 204) and to successively output, on an output (116) of the digital-analog converter (106, 224) each of the M analog converted digital samples (9) which together form an analog signal (11) which is representative of the waveform.

2. Transmitter device (100, 200, 300) according to claim 1, the delay line (102, 202) including at least M delay cells (120, 120.1 to 120.7) connected to each other in series, each delay cell (120, 120.1 to 120.7) being designed to apply a delay to a signal (130, 130.1 to 130.7) entering in this cell (120, 120.1 to 120.7) and to output said delayed input signal to the memory (104, 204) as one of the M delayed signals (12.1 to 12.7).

3. Transmitter device (100, 200, 300) according to claim 2, the delays applied by the delay cells (120, 120.1 to 120.7) between two consecutive signals among the M delayed signals (12.1 to 12.7) being approximately similar.

4. Transmitter device (100, 200, 300) according to one of claims 2 or 3, each delay cell (120, 120.1 to 120.7) including at least one control input (134, 134.1 to 134.7), the duration of the delay applied by each of the delay cells (120, 120.1 to 120.7) depending on a control voltage or current applied to the control input (134, 134.1 to 134.7) of said delay cell (120, 120.1 to 120.7).

5. Transmitter device (100, 200, 300) according to claim 4, each delay cell (120) further including two MOS inverters (122, 124) connected in series and at least one MOS transistor (126) connected to one of the MOS inverters (122), the control input (134) of each delay cell (120) being connected to a fate of the MOS transistor (126) of this delay cell (120).

6. Transmitter device (100, 200, 300) according to claim 5, each delay cell (120) further including a second MOS transistor (128) connected to the other of the MOS inverters (124), the control input (134) of each delay cell (120) being connected to a gate of the second MOS transistor (128) of this delay cell (120).

7. Transmitter device (100, 200, 300) according to one of claims 2 to 4, each delay cell (120) including at least two NMOS transistors (129, 131), one drain of each NMOS transistor (129, 131) being connected to a resistor (125, 127), the input (130) of each delay cell (120) being applied in a differential manner between the gates of the NMOS transistors (129, 131) and the output (132) of each delay cell (120) being taken in a differential manner between the drains of the NMOS transistors (129, 131).

8. Transmitter device (100, 200, 300) according to one of the preceding claims, the delay line (102, 202) including at least one delay locked loop.

9. Transmitter device (100, 200, 300) according to claim 8, the delay locked loop including at least one phase comparator (133) and a low-pass filter (135, 137).

10. Transmitter device (100, 200, 300) according to one of the preceding claims, the M digital samples (9) of the waveform being stored sequentially in the memory (104, 204) without addressing.

11. Transmitter device (100, 200, 300) according to one of the preceding claims, the memory (104, 204) including at least M columns of N storage elements (136), also forming N lines of M storage elements (136).

12. Transmitter device (100, 200, 300) according to claim 11, the memory (104,204) further including M AND logic gates (142) designed to carry out an AND logic operation between one of the M delayed signals and another one of the M delayed signals which is inverted.

13. Transmitter device (100, 200, 300) according to claim 12, each storage element (136) including at least two inverters (138) looped to each other and at least two MOS transistors (140), each MOS transistor (140) being respectively linked to an input of one of the inverters (138), the gates of the MOS transistors (140) of N storage elements (136) which are in a given column being connected to the output of one of the M AND logic gates (142) of the memory (104, 204).

14. Transmitter device (100, 200, 300) according to claim 12, each storage element (136) including at least one flip-flop (148) and an AND logic gate (150), one input of each of said AND logic gates (150) of the N storage elements (136) in a given column being connected to the output of one of the M AND logic gates (142) of the memory (104, 204), another input of each of said AND logic gates (150) being connected to the output of said flip-flop (148) which is in the same storage element (136) as said AND logic gate (150).

15. Transmitter device (100, 200, 300) according to claim 11, each storage element (136) including at least one flip-flop (148) and an AND logic gate (150), one input of each of said AND logic gates (150) of the N storage elements (136) in a given column being designed to receive one of the M delayed signals, another input of each of said AND logic gates (150) being connected to the output of said flip-flop (148) in the same storage element (136) as said AND logic gate (150).

16. Transmitter device (100, 200, 300) according to one of claims 14 or 15, the outputs of M AND logic gates (150) of a line of M storage elements (136) being connected to at least M inputs of an OR logic gate (152) and/or an exclusive OR logic gate (154).

17. Transmitter device (200, 300) according to one of the preceding claims, which also includes a second memory, in which are stored digital samples of a plurality of waveforms, connected to the other memory (204), the transmitter device (200, 300) being designed to transfer digital samples of at least one of the plurality of stored waveforms from the second memory into the other memory (204).

18. Transmitter device (100, 200, 300) according to one of the preceding claims, the memory (104, 204) being designed to store the M digital samples (9) of the waveform from a data file.

19. Transmitter device (100, 200, 300) according to one of the preceding claims, one of the N inputs (114.1 to 114.6) of the digital-analog converter (106, 224), to which a n-th bit of the digital samples is intended to be outputted, being connected to a n-th amplifier (156.1 to 156.6) which includes at least $2^n$ COS inverters connected in parallel.

20. Transmitter device (100, 200) according to one of the preceding claims, the digital-analog converter (106, 224) carrying out a conversion operation in accordance with the equation:

$$Vs = \frac{1}{2^N - 1} \sum_{n=0}^{N} 2^n . V(n) \, ,$$

where

- Vs: analog signal voltage obtained at the output of the converter,
- V(n): voltage of a n-th bit of one of the M digital samples.

21. Transmitter device (100, 200, 300) according to one of claims 1 to 18, one of the N inputs (114.1 to 114.4) of the digital-analog converter (106, 224), to which a n-th amplitude bit of the digital samples is intended to be outputted, being connected to at least two AND logic gates (164.1 to 164.4, 166.1 to 166.4, 208) respectively connected to two n-th amplifiers (160.1 to 160.4, 162.1 to 162.4, 214, 216) made using $2^n$ CMOS inverters connected in parallel, one of the N inputs (114.5) of the digital-analog converter (106,224), to which a sign bit of the digital samples is intended to be outputted, being connected to all said AND logic gates (164.1 to 164.4, 166.1 to 166.4, 208) of the digital-analog converter (106, 224).

22. Transmitter device (100, 300) according to one of claims 1 to 18 or 21, the digital-analog converter (106, 224) carrying out a conversion operation in accordance with the equation:

$$Vs = \frac{2.S}{2^{N-1} - 1} \sum_{n=0}^{N-1} 2^n . V(n) \, ,$$

where

- Vs: analog signal voltage obtained at the output of the converter;
- S: sign bit of the digital samples which may take one of the values -1 or +1;
- V(n): voltage of a n-th bit of one of the M digital samples;
- N: number of bits of one of the M digital samples (N-1 amplitude bits + 1 sign bit).

23. Transmitter device (200, 300) according to one of the preceding claims, the digital-analog converter (224) further including capacitors (218) designed to filter the analog signal (11).

24. Transmitter device (300) according to one of the preceding claims, further including a plurality of AND logic gates (302) connected to the outputs of the memory (204) to which the N-1 amplitude bits of the M digital samples are supplied, and an exclusive OR gate (304) connected to the output of the memory (204) to which the sign bit of the M digital samples is outputted, the outputs of said AND logic gates (302) and of said exclusive OR gate (304) being connected to the digital-analog converter (224).

25. Transmitter device (200, 300) according to one of the preceding claims, further including at least one transformer (220), such as a balun type transformer, suitable for receiving the analog signal (11) as an input.

26. Transmitter device (100, 200, 300) according to one of the preceding claims, further including means for amplifying the analog signal obtained at the output of the digital-analog converter (106).

27. Transmitter device (100, 200, 300) according claim 26, the means for amplifying also carrying out filtering of the analog signal obtained at the output of the digital-analog converter (106).

28. Transmitter device (100) according to one of claims 1 to 24, further including means for filtering (108) the analog signal (10) obtained at the output of the digital-analog converter (106).

29. Transmitter device (100) according to claim 26, further including means for filtering the analog signal (10), an output of the amplification means being connected to an input of the filtering means.

30. Transmitter device (100) according to one of claims 28 or 29, the filtering means (108) including at least one low-pass filter and/or at least one band-pass filter.

31. Transmitter device (100, 200, 300) according to one of the preceding claims, the analog signal being a signal whose frequency is between about 1 GHz and 10 GHz.

32. Transmitter device (100, 200, 300) according to one of the preceding claims, the analog signal including at least one ultra-wide band (UWB) pulse.

33. Transmitter device (100, 200, 300) according to one of the preceding claims, the analog signal including at least one burst of pulses in accordance with the IEEE 802.15.4a standard.

34. Method for transmitting signals which includes at least the steps of:

  - creating M signals which are delayed (12.1 to 12.7) in relation to each other, where M is a non-zero integer,
  - outputting M stored digital samples (9) of N bits of a waveform, where each of the samples (9) is successively outputted on N output lines (114) respectively under the control of one of the M delayed signals (12.1 to 12.7),
  - analog conversion of the M digital samples (9) and successively outputting to an output (116) of each of the M analog converted digital samples (9) which together form an analog signal (11) which is representative of the waveform.

35. Transmission method according to claim 34, each of the M delayed signals (12.1 to 12.7) including at least one step signal, and/or a rising or falling front, and/or a clock signal.

36. Transmission method according to one of claims 34 or 35, the delays between two consecutive signals among the M delayed signals (12.1 to 12.7) being approximately similar.

37. Transmission method according to claim 36, the M delayed signal (12.1 to 12.7) being obtained from a clock signal (10) of period Tref, an i-th signal from the M delayed signals (12.1. to 12.7) including the delayed clock signal (10) with a delay approximately equal to $Td_i = i \times Td_0$, where $Td_0 = \dfrac{Tref}{j}$, j being a non-zero real number which defines the elementary delay $Td_0$ in relation to Tref.

38. Transmission method according to claim 37, delays of the M delayed signals (12.1 to 12.7) being adjusted by a control voltage or current obtained by measuring a phase error of the clock signal (10).

39. Transmission method according to one of claims 34 to 38, the M stored digital samples (9) being outputted at the sampling frequency of the wave formed by the digital samples (9).

40. Transmission method according to one of claims 34 to 39, the analog conversion of the M digital samples (9) being carried out in accordance with the equation:

$$Vs = \frac{1}{2^N - 1} \sum_{n=0}^{N} 2^n . V(n) \; ,$$

where

• Vs: voltage of the analog signal obtained,
• V(n): voltage of a n-th bit of one of the M digital samples.

41. Transmission method according to one of claims 34 to 39, the analog conversion of the M digital samples (9) being carried out in accordance with the equation:

$$Vs = \frac{2.S}{2^{N-1} - 1} \sum_{n=0}^{N-1} 2^n . V(n) \; ,$$

where

• S: sign bit of the digital samples which may take one of the values -1 or +1,
• Vs: voltage of the analog signal obtained,
• V(n) : voltage of a n-th bit of one of the M digital samples,
• N: number of bits of one of the M digital samples (N-1 amplitude bits + 1 sign bit).

42. Transmission method according to one of claims 34 to 41, further including, after the analog conversion step, a filtering step and/or an amplification step.

43. Transmission method according to one of claims 34 to 42, further including, after the step in which M stored digital samples (9) are outputted, a step for polarity modulation of the M digital samples, such as BPSK and/or DBPSK and/or OOK modulation.

**Patentansprüche**

1. Sendeeinrichtung (100, 200, 300), wenigstens umfassend:

- eine Verzögerungsleitung (102, 202), fähig M gegeneinander verzögerte Signale (12.1 bis 12.7) zu liefern, wobei M eine ganze Zahl größer als 1 ist,
- einen Speicher (104, 204), fähig mindestens M digitale Abtastwerte (9) einer Wellenform zu speichern, wobei jeder digitale Abtastwert (9) N Bits umfasst, und sukzessive jeden der M digitalen Abtastwerte auf N Ausgangsleitungen (114) zu liefern, jeweils durch den Befehl eines der verzögerten Signale (12.1 bis 12.7),
- einen Digital-Analog-Wandler (106, 224) mit N Eingängen (114), verbunden mit N Ausgangsleitungen (114), fähig die als Eingang von den N Ausgangsleitungen (114) des Speichers (104, 204) empfangenen M digitalen Abtastwerte (9) umzuwandeln und sukzessiv auf einem Ausgang (116) des Digital-Analog-Wandlers (106, 224) jeden der M analog konvertierten digitalen Abtastwerte (9) zu liefern, die zusammen ein repräsentatives analoges Signal (11) der Wellenform bilden.

2. Sendeeinrichtung (100, 200, 300) nach Anspruch 1, wobei die Verzögerungsleitung (102, 202) wenigstens M in Serie miteinander verbundene Verzögerungszellen (120, 120.1 bis 120.7) umfasst und jede Verzögerungszelle dabei fähig ist, ein in diese Zelle (120, 120.1 bis 120.7) eingespeistes Signal (130, 130.1 bis 130.7) zu verzögern und dem Speicher (104, 204) das genannte eingespeiste und verzögerte Signal als eines der M verzögerten Signale (12.1 bis 12.7) zu liefern.

3. Sendeeinrichtung (100, 200, 300) nach Anspruch 2, wobei die durch die Verzögerungszellen (120, 120.1 bis 120.7) angewandten Verzögerungen zwischen zwei aufeinanderfolgenden Signalen unter den M verzögerten Signalen (12.1 bis 12.7) im Wesentlichen gleich sind.

4.  Sendeeinrichtung (100, 200, 300) nach einem der Ansprüche 2 oder 3, wobei jede Verzögerungszelle (120, 120.1 bis 120.7) wenigstens einen Steuereingang (134, 134.1 bis 134.7) umfasst und die Dauer der durch jede der Verzögerungszellen (120, 120.1 bis 120.7) angewandten Verzögerung von einer Steuerspannung oder einem Steuerstrom abhängt, angewandt am Steuereingang (134, 134.1 bis 134.7) der genannten Verzögerungszelle (120, 120.1 bis 120.7).

5.  Sendeeinrichtung (100, 200, 300) nach Anspruch 4, bei der jede Verzögerungszelle (120) außerdem zwei in Serie verbundene MOS-Inverter (122, 124) und wenigstens einen mit einem der MOS-Inverter (122) verbundenen MOS-Transistor (126) umfasst, wobei der Steuereingang (134) jeder Verzögerungszelle mit einem Gate des MOS-Transistors (126) dieser Verzögerungszelle (120) verbunden ist.

6.  Sendeeinrichtung (100, 200, 300) nach Anspruch 5, bei der jede Verzögerungszelle (120) außerdem einen zweiten, mit dem anderen MOS-Inverter (124) verbundenen MOS-Transistor (128) umfasst, wobei der Steuereingang (134) jeder Verzögerungszelle (120) mit einem Gate des zweiten MOS-Transistors (128) dieser Verzögerungszelle (120) verbunden ist.

7.  Sendeeinrichtung (100, 200, 300) nach einem der Ansprüche 2 bis 4, bei der jede Verzögerungszelle (120) wenigstens zwei NMOS-Transistoren (129, 131) umfasst, wobei ein Drain jedes NMOS-Transistors (129, 131) mit einem Widerstand (125, 127) verbunden ist und der Eingang (130) jeder Verzögerungszelle (120) auf differentielle Weise zwischen die Gates der NMOS-Transistoren (129, 131) gelegt wird und der Ausgang (132) jeder Verzögerungszelle (120) auf differentielle Weise zwischen den Drains der NMOS-Transistoren (129, 131) abgegriffen wird.

8.  Sendeeinrichtung (100, 200, 300) nach einem der vorhergehenden Ansprüche, bei der die Verzögerungsleitung (102, 202) wenigstens eine Verzögerungsschleife (DLL) umfasst.

9.  Sendeeinrichtung (100, 200, 300) nach Anspruch 8, bei der die Verzögerungsschiefe (DLL) wenigstens einen Phasenkomparator (133) und ein Tiefpassfilter (135, 137) umfasst.

10.  Sendeeinrichtung (100, 200, 300) nach einem der vorhergehenden Ansprüche, wobei die M digitalen Abtastwerte (9) der Wellenform sequentiell ohne Adressierung in dem Speicher (104, 204) gespeichert werden.

11.  Sendeeinrichtung (100, 200, 300) nach einem der vorhergehenden Ansprüche, wobei der Speicher (104, 204) wenigstens M Spalten mit N Speicherelementen (136) umfasst und ebenfalls N Zeilen mit M Speicherelementen (136) bildet.

12.  Sendeeinrichtung (100, 200, 300) nach Anspruch 11, wobei der Speicher (104, 204) außerdem M AND-Gatter (142) umfasst, befähigt für eine logische AND-Operation zwischen einem der M verzögerten Signale und einem anderen der M invertierten verzögerten Signale.

13.  Sendeeinrichtung (100, 200, 300) nach Anspruch 12, bei der jedes Speicherelement (136) wenigstens zwei miteinander ringgeschaltete Inverter (138) und wenigstens zwei MOS-Transistoren (140) umfasst, wobei jeder MOS-Transistor (140) jeweils mit einem Eingang eines der Inverter (138) verbunden ist und die Gates der MOS-Transistoren (140) von N in einer selben Spalte befindlichen Speicherelementen (136) verbunden sind mit dem Ausgang eines der M AND-Gatter (142) des Speichers (104, 204).

14.  Sendeeinrichtung (100, 200, 300) nach Anspruch 12, bei der jedes Speicherelement (136) wenigstens eine Kippstufe (148) und ein AND-Gatter (150) umfasst, wobei ein Eingang jedes der genannten AND-Gatter (150) der N Speicherelemente (136), die sich in einer selben Spalte befinden, verbunden ist mit dem Ausgang eines der M AND-Gatter (142) des Speichers (104, 204), und ein anderer Eingang jedes der genannten AND-Gatter (150) verbunden ist mit dem Ausgang der genannten Kippstufe (148), die sich in demselben Speicherelement (136) wie das genannte AND-Gatter (150) befindet.

15.  Sendeeinrichtung (100, 200, 300) nach Anspruch 11, bei der jedes Speicherelement (136) wenigstens eine Kippstufe (148) und ein AND-Gatter (150) umfasst, wobei ein Eingang jedes der genannten AND-Gatter (150) der N Speicherelemente (136), die sich in einer selben Spalte befinden, eines der N verzögerten Signale empfangen kann, und ein anderer Eingang jedes der genannten AND-Gitter mit einem Ausgang der genannten Kippstufe (148) verbunden ist, die sich in demselben Speicherelement (136) wie das genannte AND-Gatter (150) befindet.

16. Sendeeinrichtung (100, 200, 300) nach einem der Ansprüche 14 oder 15, wobei Ausgänge der M AND-Gatter (150) einer Zeile von M Speicherelementen (136) verbunden sind mit wenigstens M Eingängen eines OR-Gatters (152) und/oder eines XOR-Gatters (154).

17. Sendeeinrichtung (200, 300) nach einem der vorhergehenden Ansprüche mit außerdem einem zweiten Speicher, in dem digitale Abtastwerte einer Vielzahl von Wellenformen gespeichert sind und der verbunden ist mit dem anderen Speicher (204), wobei die Sendeeinrichtung (200, 300) fähig ist, aus der Vielzahl von Wellenformen von digitalen Abtastwerten, die in dem zweiten Speicher gespeichert sind, wenigstens eine in den anderen Speicher (204) zu transferieren.

18. Sendeeinrichtung (100, 200, 300) nach einem der vorhergehenden Ansprüche, wobei der Speicher (104, 204) fähig ist, die M digitalen Abtastwerte (9) der Wellenform aus einer Datendatei abzuspeichern.

19. Sendeeinrichtung (100, 200, 300) nach einem der vorhergehenden Ansprüche, wobei einer der N Eingänge (114.1 bis 114.6) des Digital-Analog-Wandlers (106, 224), vorgesehen zur Lieferung eines n-ten Bits der digitalen Abtastwerte, verbunden ist mit einem n-ten Verstärker (15.1 bis 156.6), der wenigstens $2^n$ parallel geschaltete CMOS-Inverter umfasst.

20. Sendeeinrichtung (100, 200) nach einem der vorhergehenden Ansprüche, wobei der Digital-Analog-Wandler (106, 224) eine Wandlungsoperation gemäß der folgenden Gleichung realisiert:

$$Vs = \frac{1}{2^N - 1} \sum_{n=0}^{N} 2^n . V(n) \, ,$$

mit

- Vs : Spannung des am Ausgang des Wandlers erhaltenen analogen Signals,
- V(n) : Spannung eines n-ten Bits eines der M digitalen Abtastwerte.

21. Sendeeinrichtung (100, 200, 300) nach einem der Ansprüche 1 bis 18, wobei einer der N Eingänge (114.1 bis 114.4) des Digital-Analog-Wandlers (106, 224), bestimmt zur Lieferung eines n-ten Bits der Amplitude der digitalen Abtastwerte, verbunden ist mit wenigstens zwei AND-Gattern (164.1 bis 164.4, 166.1 bis 166.4, 208), jeweils verbunden mit zwei n-ten Verstärkern (160.1 bis 160.4, 162.1 bis 162.4, 214, 216), realisiert aus $2^n$ parallel geschalteten CMOS-Invertern, wobei einer der N Eingänge (114.5) des Digital-Analog-Wandlers (106, 224), bestimmt zur Lieferung eines Vorzeichenbits der digitalen Abtastwerte, verbunden ist mit allen genannten AND-Gatter (164.1 bis 164.4, 166.1 bis 166.4, 208) des Digital-Analog-Wandlers (106,224).

22. Sendeeinrichtung (100, 300) nach einem der Ansprüche 1 bis 18 oder 21, wobei der Digital-Analog-Wandler (106, 224) eine Wandlungsoperation gemäß der folgenden Gleichung realisiert:

$$Vs = \frac{2.S}{2^{N-1} - 1} \sum_{n=0}^{N-1} 2^n . V(n) \, ,$$

mit

- Vs : Spannung des am Ausgang des Wandlers erhaltenen analogen Signals;
- S : Vorzeichenbit der digitalen Abtastwerte, das einen der Werte -1 oder +1 annehmen kann;
- V(n) : Spannung eines n-ten Bits eines der M digitalen Abtastwerte;
- N : Anzahl der Bits eines der M digitalen Abtastwerte (N-1 Amplitudenbits + 1 Vorzeichenbit).

23. Sendeeinrichtung (200, 300) nach einem der vorhergehenden Ansprüche, wobei der Digital-Analog-Wandler (224) außerdem Kondensatoren (218) umfasst, bestimmt zur Filterung des analogen Signals (11).

24. Sendeeinrichtung (300) nach einem der vorhergehenden Ansprüche mit außerdem einer Vielzahl von AND-Gattern (302), verbunden mit den Ausgängen des Speichers (204), auf denen N-1 Amplitudenbits der M digitalen Abtastwerte geliefert werden, und ein XOR-Gatter (304), verbunden mit dem Ausgang des Speichers (204), auf dem ein Vorzeichenbit der M digitalen Abtastwerte geliefert wird, wobei die Ausgänge der genannten AND-Gatter (302) und des genannten XOR-Gatters (304) mit dem Digital-Analog-Wandler (224) verbunden sind.

25. Sendeeinrichtung (200, 300) nach einem der vorhergehenden Ansprüche mit außerdem wenigstens einem Transformator (220), etwa einem Transformator des Balun-Typs, fähig am Eingang das analoge Signal (11) zu empfangen.

26. Sendeeinrichtung (100, 200, 300) nach einem der vorhergehenden Ansprüche mit außerdem Einrichtungen zur Verstärkung des am Ausgang des Digital-Analog-Wandlers (106) erhaltenen analogen Signals.

27. Sendeeinrichtung (100, 200, 300) nach Anspruch 26, wobei die Verstärkungseinrichtungen auch eine Filterung des am Ausgang des Digital-Analog-Wandlers (106) erhaltenen Signals realisieren.

28. Sendeeinrichtung (100) nach einem der Ansprüche 1 bis 24, mit außerdem Filtereinrichtungen (108) des am Ausgang des Digital-Analog-Wandlers (106) erhaltenen analogen Signals (10).

29. Sendeeinrichtung (100) nach Anspruch 26, mit außerdem Filtereinrichtungen des analogen Signals (10), wobei ein Ausgang der Verstärkungseinrichtungen mit einem Eingang der Filtereinrichtungen verbunden ist.

30. Sendeeinrichtung (100) nach einem der Ansprüche 28 oder 29, wobei die Filtereinrichtungen (108) wenigstens ein Hochsperrfilter und/oder ein Tiefpassfilter umfassen.

31. Sendeeinrichtung (100, 200, 300) nach einem der vorhergehenden Ansprüche, wobei das analoge Signal ein Signal mit einer zwischen ungefähr 1 GHz und 10 GHz enthaltenen Frequenz ist.

32. Sendeeinrichtung (100, 200, 300) nach einem der vorhergehenden Ansprüche, wobei das analoge Signal mindestens einen Impuls des Ultrabreitband-Typs (UWB) umfasst.

33. Sendeeinrichtung (100, 200, 300) nach einem der vorhergehenden Ansprüche, wobei das analoge Signal wenigstens eine Impulsgruppe gemäß der Norm IEEE 802.15.4a umfasst.

34. Verfahren zum Senden von Signalen, wenigstens die folgenden Schritte umfassend:

- Realisierung von M gegeneinander verzögerten Signalen (12.1 bis 12.7), wobei M eine ganze Nichtnullzahl ist,
- Lieferung von M gespeicherten digitalen, N Bits umfassende Abtastwerten (9) einer Wellenform, wobei jeder der Abtastwerte (9) sukzessiv auf N Ausgangsleitungen (114) geliefert wird, jeweils durch den Befehl eines der M verzögerten Signale (12.1 bis 12.7),
- Analogwandlung der M digitalen Abtastwerte (9) und sukzessives Liefern jedes der analog gewandelten, zusammen ein für die Wellenform repräsentatives analoges Signal (11) bildenden Abtastwerte auf einem Ausgang (116).

35. Verfahren zum Senden von Signalen nach Anspruch 34, wobei jedes der M verzögerten Signale (12.1 bis 12.7) wenigstens ein Pegel- bzw. Eichsignal und/oder eine steigende oder fallende Impulsflanke und/oder ein Taktsignal umfasst.

36. Verfahren zum Senden von Signalen nach einem der Ansprüche 34 oder 35, wobei die Verzögerungen zwischen zwei aufeinanderfolgenden Signalen unter den M verzögerten Signalen (12.1 bis 12.7) im Wesentlichen gleich sind.

37. Verfahren zum Senden von Signalen nach Anspruch 36, wobei man die M verzögerten Signale (12.1 bis 12.7) ab einem Taktsignal (10) der Periode $Tref$ erhält, und ein i-tes Signal unter den M verzögerten Signalen (12.1 bis 12.7) das Taktsignal (10) umfasst, verzögert um eine Verzögerung im Wesentlichen gleich $Td_i = i \times Td_o$, mit $Td_o = Tref/j$, wobei $j$ eine die Elementarverzögerung $Td_o$ im Verhältnis zu $Tref$ definierende reelle Nichtnullzahl ist.

38. Verfahren zum Senden von Signalen nach Anspruch 37, wobei die M verzögerten Signale (12.1 bis 12.7) justiert werden durch eine Steuerspannung oder einen Steuerstrom, erhalten durch das Messen eines Phasenfehlers des Taktsignals (10).

39. Verfahren zum Senden von Signalen nach einem der Ansprüche 34 bis 38, wobei die M gespeicherten digitalen Abtastwerte (9) mit der Abtastfrequenz der durch die digitalen Abtastwerte gebildeten Welle geliefert werden.

40. Sendeverfahren nach einem der Ansprüche 34 bis 39, wobei die Analogwandlung der M digitalen Abtastwerte (9) gemäß folgender Gleichung realisiert wird:

$$Vs = \frac{1}{2^N - 1} \sum_{n=0}^{N} 2^n . V(n),$$

mit

- Vs : Spannung des am Ausgang des Wandlers erhaltenen analogen Signals,
- V(n) : Spannung eines n-ten Bits eines der M digitalen Abtastwerte.

41. Sendeverfahren nach einem der Ansprüche 34 bis 39, wobei die Analogwandlung der M digitalen Abtastwerte (9) gemäß folgender Gleichung realisiert wird:

$$Vs = \frac{2.S}{2^{N-1} - 1} \sum_{n=0}^{N-1} 2^n . V(n),$$

mit

- S : Vorzeichenbit der digitalen Abtastwerte, das einen der Werte -1 oder +1 annehmen kann;
- Vs : Spannung des am Ausgang des Wandlers erhaltenen analogen Signals;
- V(n) : Spannung eines n-ten Bits eines der M digitalen Abtastwerte;
- N : Anzahl der Bits eines der M digitalen Abtastwerte (N-1 Amplitudenbits + 1 Vorzeichenbit).

42. Serdeverfahren nach einem der Ansprüche 34 bis 41, außerdem nach dem Analogwandlungsschritt einen Filterschritt und/oder einen Verstärkungsschritt umfassend.

43. Sendeverfahren nach einem der Ansprüche 34 bis 42 mit außerdem - nach dem Schritt zur Lieferung der M gespeicherten digitalen Abtastwerte (9) - einem Schritt zur Modulation der Polarität der M digitalen Abtastwerte, etwa einer Modulation des Typs BPSK und/oder DBPSK und/oder OOK.

102

100

110

112

106

108

104

114

116

118

# FIG. 1

102

135

133

134.1

134.7

137

130.1

132.1

132.7

110

120.1  120.2  . . .

130.7

120.7

112.7

112.1

112.2

# FIG. 2

FIG. 3A

FIG. 3B

FIG. 3C

## FIG. 4

## FIG. 5

112.x

112.x+1

142

142

144

140

140

138

138

FIG. 6

138

138

146

140

138

140

138

136

136

112.x

112.x+1

142

142

148

148

150

150

FIG. 7

136

136

152

144

112.x                    112.x+1

148                      148

150                      150

136                      136

154                                              144

## FIG. 8

114.1                    156.1
                                                 106
114.2                    156.2

114.3                    156.3

114.4                    156.4
                                        116
114.5                    156.5
                                        FIG. 9
114.6                    156.6

FIG. 10

9

| 1 | -1 | 1 | -1 | 1 | -1 | 1 | -1 | 1 | -1 | 1 | -1 | 1 | -1 | 1 | -1 | 1 | -1 | 1 |
|---|----|---|----|---|----|---|----|---|----|---|----|---|----|---|----|---|----|---|
| 0 | 0 | 1 | 1 | 1 | 1 | 1 | 1 | 1 | 1 | 0 | 1 | 1 | 1 | 1 | 1 | 1 | 1 | 1 |
| 0 | 0 | 0 | 1 | 1 | 1 | 1 | 1 | 1 | 1 | 0 | 0 | 0 | 1 | 1 | 1 | 1 | 1 | 0 |
| 0 | 0 | 0 | 0 | 1 | 1 | 1 | 1 | 1 | 0 | 0 | 0 | 0 | 0 | 1 | 1 | 1 | 0 | 0 |
| 0 | 0 | 0 | 0 | 0 | 1 | 1 | 1 | 0 | 0 | 0 | 0 | 0 | 0 | 0 | 1 | 0 | 0 | 0 |
| 0 | 0 | 0 | 0 | 0 | 0 | 1 | 0 | 0 | 0 | 0 | 0 | 0 | 0 | 0 | 0 | 0 | 0 | 0 |

11

$T_{ech}$

13

FIG. 11

FIG. 12

FIG. 13

## RÉFÉRENCES CITÉES DANS LA DESCRIPTION

**Documents brevets cités dans la description**

- US 6603818 B
- US 6625229 B
- EP 1376149 A
- US 7010056 B
- US 6735238 B
- GB 2401016 A
- US 6985532 B

**Littérature non-brevet citée dans la description**

- **D. WENTZLOFF et al.** Gaussian Pulse Generators for Subbanded Ultra-Wideband Transmitters. *IEEE Transactions on Microwave Theory and Technics,* Avril 2006, vol. 54 (4
- **D. MARCHALAND et al.** Novel Pulse Generator Architecture Dedicated to Low Data Rate UWB Systems. *IEEE Wireless Technology 2005, the European Conference,* 03 Octobre 2005